# EUROPEAN PATENT SPECIFICATION

(11) **EP 0 601 068 B1**
(45) Date of publication and mention of the grant of the patent: **16.10.2002**
(21) Application number: 92919016.3
(22) Date of filing: 17.08.1992
(51) Int. Cl.: H01L 45/00

(54) **ELECTRICALLY ERASABLE, DIRECTLY OVERWRITABLE, MULTIBIT SINGLE CELL MEMORY ELEMENTS AND ARRAYS FABRICATED THEREFROM**
ELEKTRONISCH LÖSCHBARE, DIREKT ÜBERSCHREIBBARE MULTIBIT-EINZELZELLEN-SPEICHERELEMENTE UND AUS DIESEN HERGESTELLTE ANORDNUNGEN
MEMOIRES A UNE SEULE CELLULE MULTIBIT, ELECTRIQUEMENT EFFACABLES ET DIRECTEMENT ECRASABLES, ET MATRICES FABRIQUEES A PARTIR DE TELLES MEMOIRES

(30) Priority: 19.08.1991 US 747053; 30.09.1991 US 768139; 07.11.1991 US 789234; 08.05.1992 US 880763; 15.06.1992 US 898635
(43) Date of publication of application: 15.06.1994
(73) Proprietor: ENERGY CONVERSION DEVICES, INC., Troy Michigan 48084 (US)
(72) Inventor: OVSHINSKY, Stanford, R., Bloomfield Hills, MI 48013 (US); CZUBATYJ, Wolodymyr, Warren, MI 48092 (US); YE, Qiuyi, Mesa, Arizona 85202 (US); STRAND, David, A., West Bloomfield, MI 48323 (US); HUDGENS, Stephen, J., Southfield, MI 48075 (US); GONZALEZ-HERNANDEZ, Jesus, Royal Oak, MI 48073 (US); FRITZSCHE, Hellmut, Chicago, IL 60637 (US); KOSTYLEV, Sergey, A., Bloomfield Hills, MI 48304 (US); CHAO, Benjamin, S., Troy, MI 48083 (US)
(74) Representative: Müller, Hans-Jürgen, Dipl.-Ing.
(86) International application number: US9206876
(87) International publication number: WO93004506

(56) References cited:
- EP-A- 0 479 325
- EP-A- 0 495 494
- GB-A- 2 065 972
- US-A- 4 177 475
- US-A- 4 199 692
- US-A- 4 203 123
- US-A- 4 225 946

## Description

### FIELD OF THE INVENTION

The present invention relates to an electrically operated memory element comprising a volume of memory material formed of a semiconductor material including at least one chalcogen element and a method of modulating the electrical conductivity of these memory materials.

The mechanism of operation of devices fabricated from this semiconductor materials is different from the operation of previous semiconductor devices and can be tailored to provide new device configurations exhibiting unusual new properties.

### BACKGROUND AND PRIOR ART

The Ovonic EEPROM is a novel, proprietary, high performance, non-volatile, thin film electronic memory device. In this device, information can be stored in either analog or binary form (one bit per cell) or in multi-state form (multiple bits per memory cell). The advantages of the Ovonic EEPROM include non-volatile storage of data, potential for high bit density and consequently low cost as a result of its small footprint and simple two-terminal device configuration, long reprogramming cycle life, low programming energies and high speed. The Ovonic EEPROM is capable of binary and multistate operation. There are small differences in the structure and the materials employed to enhance either the binary or multi-state performance characteristics thertof. For purposes of the instant invention, the terms "memory elements" and "control elements" will be employed synonymously.

The operation of most semiconductor devices is governed by the control of mobile charge carrier concentrations different from that generated at thermal equilibrium. Prior to the present invention, only four general methods were known by which to control and modulate the concentration of excess or free (these two terms are used interchangeably throughout this discussion) charge carriers in solid state semiconductor devices. These four known methods will be described hereinbelow following a general discussion of those fundamental mechanisms of operation of semiconductor devices which are necessary in order to appreciate the advantages of the instant invention.

By way of explanation, in a perfect semiconductor lattice with no impurities or lattice defects -- an intrinsic semiconductor -- no charge carriers are present at zero Kelvin since the valence band is filled with electrons and the conduction band is empty. At higher temperatures, however, electron-hole pairs generated as valence band electrons are excited thermally across the band gap to the conduction band. These thermally generated electron-hole pairs are the only charge carriers present in an intrinsic semiconductor material. Of course, since the electrons and holes are created in pairs, the conduction band electron concentration (electrons per cubic centimeter) is equal to the concentration of holes in the valence band (holes per cubic centimeter). It is well known, but worth emphasizing, that if a steady state carrier concentration is to be maintained, there must be recombination of the charge carriers at the same rate that they are generated. Recombination occurs when an electron in the conduction band makes a transition to an empty state (hole) in the valence band, either directly or indirectly through the agency of a mid-gap recombination center, thus annihilating the pair.

In addition to thermally generated charge carriers, it is possible to create carriers in semiconductor materials by purposely introducing certain impurities into the crystal lattice. This process is called doping and represents a common method of varying the conductivity of semiconductors. By doping, a semiconductor material can be altered so that it has a predominance of either electrons or holes, i.e., it is either n-type or p-type. When a crystal lattice is doped such that the equilibrium carrier concentrations are different from the intrinsic carrier concentrations, the semiconductor material is said to be "extrinsic". When impurities or lattice defects are introduced into an otherwise perfect lattice crystal, additional levels are created in the energy band structure, usually within the band gap. For instance, the introduction of phosphorous in silicon or germanium, generates an energy level very near the conduction band. This new energy level is filled with electrons at zero Kelvin, and very little thermal energy is required to excite these electrons to the conduction band. Thus, at about 50-100 Kelvin, virtually all of the electrons in the impurity level are donated to the conduction band. Semiconductor material doped with donor impurities can have a considerable concentration of electrons in the conduction band, even when the temperature is too low for the intrinsic charge carrier concentration to be appreciable.

Now that the reader can appreciate the significance of the presence of excess charge carriers for electrical conductivity, it must be noted that these carriers can also be created by optical excitation or they can be injected across a forward biased p-n junction or a Schottky barrier. Simply stated and regardless of the manner in which the excess carriers are generated, they can dominate the electrical conduction processes in a semiconductor material. It has previously been stated that there are four known methods of modulating the concentration of free charge. Those four methods are described below:

(**1**) In 1948, Bardcen, Brattain, and Schockley ushered in the modern era of semiconductor electronics when they demonstrated the operation of a solid state amplifier by successfully modulating the flow of injected minority charge carriers in bipolar junction transistors. The bipolar junction transistor is a three terminal device in which the flow of current through two terminals can be controlled by small changes in the current at the third terminal. This control feature provides for the amplification of small signals or for the switching of the device from an "on" state to an "off" state. In other words, the bipolar transistor is employed to modulate the injection and collection of minority charge carriers across a semiconductor junction. More particularly, and considering, for instance, in a p-n-p bipolar structure (the operation of an n-p-n bipolar structure is simply the reverse of the operation of the p-n-p structure), the negative side of the forward biased junction is the same as the negative side of the reverse biased junction. With this configuration, the injection of holes from the p-n junction into the center n region supplies the minority carriers, holes, to participate in the reverse flow of current through the n-p junction. As should now be evident, the designation of this device as "bipolar" relates to the critical importance of the action of both electrons and holes.

In operation, the reverse saturation current through the p-n junction of the device depends upon the rate at which minority carriers are generated in the neighborhood of the junction. It is possible to increase the reverse current through the junction by increasing the rate of electron-hole pair generation. This can be accomplished with light (as discussed below with respect to photodetectors). Electrically, a convenient hole injection device is a forward biased p-n junction in which the current is due primarily to holes injected from the p region into the n material. If the n side of the forward biased junction is the same as the n side of the reverse biased junction, the resultant p-n-p structure operates when the injection of holes from the p-n junction into the center n region supplies minority carrier holes to participate in the reverse current flow through the n-p junction of the transistor. Of course, the n-region is narrowed so that the injected holes do not recombine in the n region (the base of this p-n-p bipolar transistor) before they can diffuse to the depletion layer of the reverse-biased junction.

Finally, when used as a switch, this type of transistor is usually controlled in two conduction states, referred to as the "on" state and the "off" state. While transistors do not function as a short circuit when turned on and as an open circuit when turned off, they are able to approximate these actions. In transistor switching, the emitter junction is forward biased and the collector is reverse biased,with a reasonable amount of current flowing out of the base. If the base current is switched to zero, the collector current will be negligible. This is the "off" state. However, if the base current is positive and sufficiently large, the device is driven to the saturation regime and the transistor is in its "on" state. Therefore, in the typical switching operation, the base current swings from positive to negative, thereby driving the device from saturation to cutoff and vice versa.

(**2**) The second conventional method of controlling the concentration of free charge carriers is implemented by metal-oxide-semiconductor field effect transistor (MOSFET) devices. By way of background, one of the most widely employed electronic devices, particularly in digital integrated circuits, is the metal-insulator-semiconductor (MIS) transistor. In an MIS transistor, the cancentration of charge carriers in the conduction channel is controlled by a voltage applied at a gate electrode isolated from the channel by an insulator. The resulting device may be referred to generically as an insulated-gate field effect transistor (IGFET). However, since most IGFETs are made using a metal (typically aluminum) for the gate electrode, silicon-dioxide as the insulator, and silicon as the semiconductor material, the term MOS field effect transistor or MOSFET is commonly used.

In operation of a MOSFET, consider an n-type channel formed on a p-type silicon substrate. The n-type source and drain regions are formed by diffusing or implanting dopant atoms into a lightly doped p-type substrate. A thin oxide layer separates the metal gate from the silicon surface. No current flows from the drain to the source unless there is a conducting n-channel between them, since the drain-substrate-source combination includes oppositely directed p-n junctions disposed in series. When a positive voltage is applied to the gate relative to the substrate (the source in this example), positive charge carriers are deposited on the gate metal. As a result of this deposition, negative charge carriers are induced in the underlying silicon by the formation of a depletion region. In addition, a thin surface region containing mobile electrons is formed. The induced electrons form the channel of the FET and allow current to flow from the drain to the source. The effect of the gate voltage is to vary the conductance of the induced channel for low drain-to-source voltage. The MOS field effect transistor is particularly useful in digital circuits, in which it is switched from the "off" state (no conducting channel) to the "on" state. Both n-channel and p-channel MOS transistors are in very common usage.

The MOS structure can be thought of as a capacitor in which one plate is a semiconductor. If a negative voltage is applied between the metal and the semiconductor, a negative charge is effectively deposited on the metal. In response thereto, an equal net positive charge is accumulated at the surface of the semiconductor. In the case of a p-type substrate, this occurs by hole accumulation at the semiconductor-oxide interface. Since the applied negative voltage depresses the electrostatic potential of the metal relative to the semiconductor, the electron energies are raised in the metal relative to the semiconductor. The energy bands of the semiconductor bend near the interface to accommodate the accumulation of holes. Because no current passes through the MOS structure, there is no variation in the Fermi level position within the bulk of the semiconductor. The result is a bending of the semiconductor bands near the interface so that the Fermi level is closer to the valence band adjacent the interface, thereby indicating a larger hole concentration than that arising from the doping of the p-type semiconductor material.

When a positive voltage is applied from the metal to the semiconductor, the potential of the metal increases, thereby lowering the metal Fermi level relative to its equilibrium position. As a result, the oxide conduction band is again tilted. The positive voltage deposits positive charge on the metal and effectively calls for a corresponding net negative charge at the surface of the semiconductor. Such a negative charge in p-type material arises from depletion of holes from the region near the surface which leaves behind uncompensated ionized acceptors. In the depleted region, the hole concentration decreases, bending the bands down near the semiconductor surface. If the positive charge continues to increase, the bands at the semiconductor surface bend down still further. In fact, a sufficiently large voltage can cause a large electron concentration in the conduction band. The region near the semiconductor in this case has conduction properties typical of n-type material. This n-type surface layer is formed not by doping, but by "inversion" of what was originally p-type semiconductor material due to the applied voltage. This inverted layer, separated from the underlying p-type material by a depletion region, is the key to MOS transistor operation.

(**3**) The third known method of controlling the concentration of free charge carriers is by the photogeneration of free charge carriers of both polarities. This photogeneration of free charge carriers takes place in such state-of-the-art devices as photovoltaic cells, photoresistors, photodetectors and electrophotographic drums.

In general, when excess electrons or holes are created in a semiconductor material, there is a corresponding increase in the electrical conductivity of the material. In the event that the excess charge carriers are generated from optical excitation, the resulting increase in conductivity is called "photoconductivity". When photons are directed to impinge upon a semiconductor material, those photons having energies greater than the band gap energy are absorbed and electron hole pairs generated. The electron and hole created by this absorption process are excess carriers; since they are out of balance with their environment and exist in their respective bands, they contribute to the electrical conductivity of the material.

(4) The fourth known method of modulating the free charge carrier concentration in semiconductor materials is by controlling the physical structure of chalcogenide phase change materials as they undergo reversible amorphous to crystalline phase transformations. A detailed explanation of this phenomena was reported in the early work on optical and electrical Ovonic phase change materials pioneered by S.R. Ovshinsky at Energy Conversion Devices, Inc. These materials and technology are discussed in detail below.

Since the present invention has significant scientific applicability to and immediate commercial impact on many different segments of the electronic and semiconductor industries, said invention is discussed hereinbelow in three different, but related sub-sections. More particularly, the relevance of the instant invention is discussed with respect to: (A) semiconductor devices per se; (B) optically operable, fast, non-volatile phase change memories; and (C) electrically erasable, directly overwritable, multilevel single-cell memories.

### EARLY ELECTRICAL PHASE CHANGE MEMORY

US 4 225 946 discloses methods of resetting or erasing amorphous memory devices by minimizing electromigration. These memory devices are bistable and can be switched from a stable high resistance condition into a stable low resistance condition when a voltage pulse is applied. Such pulse crystallizes the material around and in the region of the conducting filament.

The general concept of utilizing electrically writable and erasable phase change materials (i.e., materials which can be electrically switched between generally amorphous and generally crystalline states) for electronic memory applications is well known in the art and as is disclosed, for example, in U.S. Patent No. 3 271 591 to Ovshinsky, issued September 6, 1966, in U.S. Patent No. 3 530 441 to Ovshinsky, issued September 22, 1970, and in EP 0 495 494 A1 to Ovshinsky, published July 22, 1992 all of which are assigned to the assignee as the present invention. (hereinafter the "Ovshinsky patents").

As disclosed in the Ovshinsky patents, such phase change materials can be electrically switched between structural states of generally amorphous and generally crystalline local order or between different detectable sates of local order across the. entire spectmm between completely amorphous and completely crystalline states. That is, the Ovshinsky patents describe that the electrical switching of such materials is not required to take place between completely amorphous and completely crystalline states but rather can be in incremental steps reflecting changes of local order to provide a "gray scale" represented by a multiplicity of conditions of local order spanning the spectrum between the completely amorphous and the completely crystalline states. The early materials described by the Ovshinsky patents could also be switched between only two structural states of generally amorphous and generally crystalline local order to accommodate the storage and retrieval of single bits of encoded binary information.

The electrically erasable phase change memories described in the Ovshinsky patents were utilized in a number of commercially significant applications. However, due to the lack of funding necessary for commercialization, subsequent developments in other fields of solid state electronic memories eventually displaced these early electrically erasable phase change technology in the marketplace and prevented these memories from being used in electrical devices such as , for instance, personal computers.

In the typical personal computer there often are four tiers of memory. Archival information is stored in inexpensive, slow, high storage capacity, non-volatile devices such as magnetic tape and floppy disks. This information is transferred, as needed, to faster and more expensive, but still non-volatile, hard disk memories. Information from the hard disks is transferred, in turn, to the still more expensive, faster, volatile system memory which uses semiconductor dynamic RAM (DRAM) devices. Very fast computers even transfer forth and back small portions of the information stored in DRAM to even faster and even more expensive volatile static RAM (SRAM) devices so that the microprocessor will not be slowed down by the time required to fetch data from the relatively slower DRAM. Transfer of information among the tiers of the memory hierarchy occupies some of the computer's power and this need for "overhead" reduces performance and results in additional complexity in the computer's architecture. The current use of the hierarchal structure, however, is dictated by the price and performance of available memory devices and the need to optimize computer performance while minimizing cost.

The electrically erasable phase change memories described in the Ovshinsky patents, as well as subsequent electrical solid state memory, had a number of limitations that prevented their widespread use as a direct and universal replacement for present computer memory applications, such as tape, floppy disks, magnetic or optical hard disk drives, solid state disk flash, DRAM, SRAM, and socket flash memory.. Specifically, the following represent the most significant of these limitations: (i) a relatively slow (by present standards) electrical switching speed, particularly when switched in the direction of greater local order (in the direction of increasing crystallization); (ii) a relatively high input energy requirement necessary to initiate a detectable change in local order; and (iii) a relatively high cost per megabyte of stored information (particularly in comparison to present hard disk drive media).

The most significant of these limitations is the relatively high energy input required to obtain detectable changes in the chemical and/or electronic bonding configurations of the chalcogenide material in order to initiate a detectable change in local order. Also significant were the switching times of the electrical memory materials described in the Ovshinsky patents.. These materials typically required times in the range of a few milliseconds for the set time (the time required to switch the material from the amorphous to the crystalline state); and approximately a microsecond for the reset time (the time required to switch the material from the crystalline back to the amorphous state). The electrical energy required to switch these materials typically measured in the range of about a microjoule.

It should be noted that this amount of energy must be delivered to each of the memory elements in the solid state matrix of rows and columns of memory cells. Such high energy levels translate into high current carrying requirements for the address lines and for the cell isolation/address device associated with each discrete memory element. Taking into consideration these energy requirements, the choices of memory cell isolation elements for one skilled in the art would be limited to very large single crystal diode or transistor isolation devices, which would make the use of micron scale lithography and hence a high packing density of memory elements impossible. Thus, the low bit densities of matrix arrays made from this material would result in a high cost per megabyte of stored information.

By effectively narrowing the distinction in price and performance between archival, non-volatile mass memory and fast, volatile system memory, the memory elements of the present invention have the capability of allowing for the creation of a novel, non-hierarchal "universal memory system". Essentially all of the memory in the system can be low cost, archival and fast. As compared to original Ovshinsky-type phase change electrical memories, the memory materials described herein provide over six orders of magnitude faster programming time (less than 30 nanoseconds) and use extraordinarily low programming energy (less than 50 picojoules) with demonstrated long term stability and cyclability (in excess of 20 million cycles). Also, experimental results indicate that additional reductions in element size can increase switching speeds and cycle life.

In general, development and optimization of the class of chalcogenide memory materials has not proceeded at the same rate as other types of solid state electrical memories that now have substantially faster switching times and substantially lower set and reset energies. These other forms of memories typically employ several solid state microelectronic circuit elements for each memory bit (as many as three or four transistors per bit) in some memory applications. The primary "non-volatile" memory elements in such solid state memories, such as EEPROM, are typically floating gate field effect transistor devices which have limited re-programmability and which hold a charge on the gate of a field effect transistor to store each memory bit. Since this charge can leak off with the passage of time, the storage of information is not truly non-volatile as it is in the phase change media of the prior art where information is stored through changes in the actual atomic configuration or electronic structure of the chalcogenide material from which the elements are fabricated. These other forms of memories now enjoy some limited acceptance in the marketplace.

In contrast to DRAM and SRAM volatile memory devices and unlike other "flash" devices, such as floating gate structures, no field effect transistor devices are required in the electrical memory devices of the present invention. In fact the electrically erasable, directly overwritable memory elements of the present invention represent the simplest electrical memory device to fabricate, comprising only two electrical contacts to a monolithic body of thin film chalcogenide material and a semiconductor diode for isolation. As a result, very little chip "real estate" is required to store a bit of information, thereby providing for inherently high density memory chips. Further, and as described below, additional increases in information density can be accomplished through the use of multibit storage in each discrete memory cell.

The solid state, electronic memories presently in use are relatively expensive to manufacture, the cost being typically about twice the cost per bit of storage capacity in relation to magnetic disk storage. On the other hand, these solid state, electronic memories provide certain advantages over magnetic disk memories in that they have no moving parts, require less electrical energy to operate, are easy to transport and store, and are more versatile and adaptable for use with portable computers and other portable electronic devices. As a matter of fact, hard drive manufacturers are forecasting rapid growth in the use of ever smaller hard drives and eventually solid state memory storage in the portable computer field. In addition, these solid state memories are usually true random access systems as opposed to disk types which require physical movement of the disk head to the proper data track for accessing the desired memory location. However, in spite of such advantages, the higher cost of solid state electrically erasable memories have prevented them from enjoying a substantial share of the market now dominated by magnetic memory systems. Although solid state electrically erasable memories could potentially be manufactured at reduced cost, the overall performance parameters of these materials are inadequate for them to fully replace magnetic disk systems.

We previously mentioned that there were only four known types of semiconductor devices which could be employed to modulate the concentration of free charge. Each of those devices were then discussed in some detail. A fifth semiconductor device which can be set to a plurality of different resistance values by relatively low energy pulses and which is capable of relatively fast switching characteristics will now be discussed in detail. After carefully perusing the following paragraphs describing the performance characteristics and the physics behind the operation of the device, the reader will understand why it was not categorized as a fifth type of charge concentration modulating semiconductor device.

A recently developed memory device is the metal-amorphous silicon-metal (MSM) electrical memory switch. See Rose, et al, "Amorphous Silicon Analogue Memory Devices", Journal of Non-Crystalline Solids, 115(1989), pp.168-70 and Hajto, et al, "Quantized Electron Transport in Amorphous -Silicon Memory *Structures",* Physical Review Letters, Vol.66, No. 14, April 8, 1991, pp. 1918-21. This MSM switch is fabricated by the deposition of specifically selected metallic contacts on either side of a p-type amorphous silicon (a-Si) thin film. The importance of the selection of the metallic contact materials will be discussed later. MSM memory switches are disclosed as exhibiting relatively fast (10-100 ns) analogue switching behavior for voltage pulses of from 1-5 volts, thereby providing a range of resistances of from about 10³ to about 10⁶ ohms to which they can be set in a non-volatile manner. As should be readily apparent to skilled practitioners in the art, the MSM memory switches of Rose, et al and Hajto, et al, although exhibiting electrical switching characteristics (i.e.,times, energies and resultant device resistance) similar to the electrical switching characteristics of the memory elements of the instant invention, there are actually significant operational differences therebetween.

The most significant electrical switching difference resides in the inability of the MSM memory switches to be directly overwritten. That is, the MSM switches cannot be modulated directly bidirectionally from any one resistance in the analogue range of resistances to any other resistance in that range without first being erased (set to a specific starting resistance or "starting state"). More specifically, the MSM switch must first be set to the high resistance state (erased) before said switch can be set to another resistance value within the analogue range. In contrast thereto, the memory elements of the instant invention do not require erasure before being set to another resistance in the range; i.e., they are directly overwritable.

Another significant difference in the electrical switching characteristics which exists between the MSM memory switches of Rose, et al and Hajto, et al and the electrical memory elements of the present invention is the bipolar behavior of the said switches. As is disclosed by Rose, et al, the MSM switches must be erased using electrical pulses of reverse polarity from those pulses used to write. Significantly, this reversal of polarity of the applied pulse is not required by the memory elements of the present invention, whether the instant memory elements are used for digital or analogue switching.

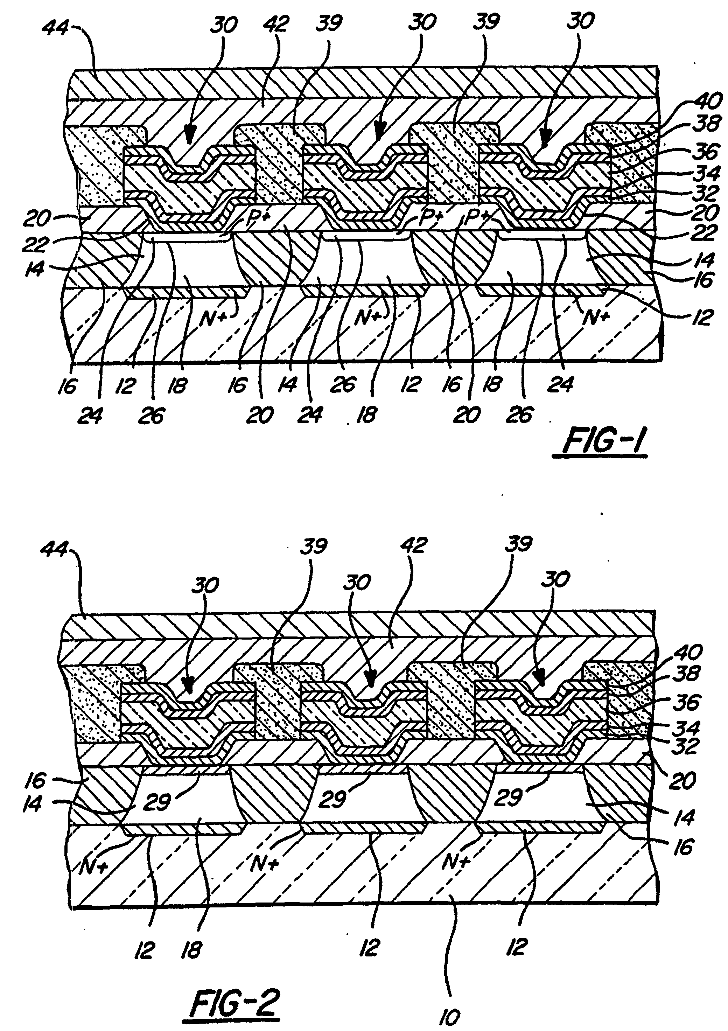

These differences in electrical switching characteristics between the MSM switches and the memory elements of the present invention are attributable to more than just a mere difference in material from which the elements are constructed. These differences are indicative of the fundamental differences in switching mechanisms which characterize the physics of operation of the two devices. As alluded to above and as disclosed in the aforementioned articles, the electrical switching characteristics of the MSM memory switches are critically dependent upon the particular metal(s) from which the contacts are fabricated. This is because these MSM switches require a very highly energetic "forming" process in which metal from at least one of the contacts is transported into and formed as an integral portion of the switch body. In this process, a plurality (at least 15 from Fig. 1 of the Rose, et al paper) of progressively increasing 300 nanosecond, 5-15 volt pulses are employed to form the switch. Rose, et al state: "...X-ray microanalysis studies of the devices have been carried out, and the top electrode material has been found embedded in a filamentary region of the a-Si. This suggests that the top metal becomes distributed in the filament, and may play a role in the mechanism of switching...." Rose, et al also specifically find that the dynamic range of the available resistances is determined by the metal from which the upper electrode contact is fabricated. As is stated by Rose, et al: ...it is found that its value is entierly (sic) dependent on the top contact, and completely independent of the bottom metallisation (sic), i.e. Cr top electrode devices are always digital and V top electrode devices are always analogue irrespective of the bottom electrode...."

It is within this metallic filamentary region where the electrical switching occurs; and without this mass migration of metal into the a-Si, there would be no switching, see the Hajto, et al paper. In complete contradistinction thereto, the memory elements of the present invention do not require migration of the contact material into the thin-film memory element to achieve high speed, low energy, analogue, *direct overwrite*, memory switching. As a matter effect, in the fabrication of the memory elements of the instant invention, great care is taken to prevent the diffusion of the metal from either of the electrodes into the active chalcogenide material. In one embodiment of the device described in the instant invention, the electrodes are each fabricated as a bilayered structure in which, for instance, carbon forms a thin film barrier to prevent migration or diffusion of, for instance, molybdenum into the chalcogenide switching material.

From the foregoing analysis of Rose, et al and Hajto, et al, it should be clear that *MSM* memory switches do not, by any stretch of the imagination qualify as a modulator of free charge concentration. Rather, MSM memory switches simply rely upon the creation of a filamentary metallic pathway through the amorphous silicon material in order to obtain a range of resistivities in much the same way as a modulated switch is used to control the flow of electrical current. A percolation pathway is established the diameter of which can be increased or decreased to change the resistivity thereof. No movement of Fermi level position is involved in the switching process. No change in activation of the semiconductor material need be invoked to explain the operation. No atomic scale movement of lone pairs of non-bonding electrons is present. Crystallite size and surface to volume ratio thereof is not important. But most importantly, it is impossible for Rose, et al and Hajto, et al to directly overwrite information stored in the cells of their memory material. The MSM switch requires stored information to be erased before new information can be written. It is not surprising that Rose, et al have asserted that their MSM switch is limited to one million cycles while the memory elements of the instant invention were cycled over 20 million cycles without failure prior to ending the test.

Simply stated, no solid state memory system developed prior to the present invention, regardless of the materials from which it was fabricated, has been inexpensive; easily manufacturable; non-volatile; electrically writable and directly erasable (overwritable) using low input energies; capable of multibit storage in a single cell (had a gray scale); and capable of very high packing density. The memory system described hereinbelow, because it addresses all of the deficiencies of known memory systems, will find immediate widespread use as a universal replacement for virtually all types of computer memory currently in the marketplace. Further, because the memories of the present invention can be fabricated in an all thin-film format, three-dimensional arrays are possible for high speed, high density neural network, and artificial intelligence applications. The memory system of the present invention is therefore uniquely applicable to neural networks and artificial intelligence systems because its multi-layer, three-dimensional arrays provide massive amounts of information storage that is rapidly addressable, thus permitting learning from stored information.

It is clear from the discussion above that the quantitative changes in switching speed and energy requirements of the memories of the present invention, as compared to the phase change memories of the prior art, demonstrate that those memories define an entirely new class of modulatable semiconductor material. In addition, the prior art has no analog to the direct overwrite, wide dynamic range and multibit storage capabilities of the instant memory elements. Further, the operation of the semiconductor materials of the present invention occurs solely in the crystalline state and is therefore vastly different from the operation of all prior art electrical memory elements which have either relied upon crystalline-to-amorphous phase transitions, or depended upon the continual application of a current amplification field. Moreover, that difference is a consequence of the manner in which not only the concentration of free charge can be modulated, inter alia, by an electric field, but the fact that the new concentration of free charge to which the device has been modulated remains constant after that electric field has been removed. This feature represents a fifth and fundamentally new mechanism for modulating the concentration of free charge in semiconductor devices and makes possible a range of new and simple switching and amplification techniques which have the capability of significantly impacting the semiconductor industry.

As should be abundantly clear to ordinarily skilled artisans, in order to address the flash EEPROM market and be seriously considered as a universal memory, it is essential that memory elements be truly non-volatile. This is even more significant if the memory element is claimed to possess multibit storage capabilities. If a set resistance value is lost or even found to significantly drift over time, the information stored therein is destroyed, users lose confidence in the archival capabilities of the memory and the technology loses all credibility. Any drift with time, regardless of how small, cannot be tolerated and will continue to be a focal point in the development of this new class of memory elements. This will be true because other compositions subsequently developed to improve switching speed, energy, etc., will also require optimization for stability.

In addition to set resistance stability, another highly important factor which would be required of a universal memory is low switching current. This is extremely significant when the EEPROMs are used for large scale archival storage. Used in this manner, the EEPROMs would replace the mechanical hard drives (such as magnetic or optical hard drives) of present computer systems. One of the main reasons for this replacement of conventional mechanical hard drives with EEPROM "hard drives" would be to reduce the comparatively large power consumption of the mechanical systems. In the case of lap-top computers, this is of particular interest because the mechanical hard disk drive is one of the largest power consumers therein. Therefore, it would be especially advantageous to reduce this power load, thereby substantially increasing the usage time of the computer per charge of the power cells. However, if the EEPROM replacement for mechanical hard drives has high switching current requirements (and therefore high power requirements), the power savings may be inconsequential or at best unsubstantial. Therefore, any EEPROM which is to be considered a universal memory requires low switching current.

Yet another requirement of a EEPROM universal memory is high thermal stability of the information stored therein. Today's computers, especially personal computers, are routinely subjected to high temperatures. These high temperatures can be caused by internally created heat such as from power sources or other heat producing internal components. These high temperatures may also be caused by environmental factors, such as use of the computer in a hot climate or storage of the computer in an environment which is directly or indirectly heated to higher than normal temperatures. Whatever the cause of the elevated temperatures, present computer memory systems, especially "hard" or archival memory, must be thermally stable even at relatively high temperatures. Without this thermal stability data loss may occur leading to the aforementioned loss of credibility. To be competitive with present memory systems, which are fairly thermally stable, a EEPROM replacement will require a thermal stability at least comparable to that of the present memory systems.

Still another requirement of a EEPROM universal memory is long write/erase cycle life. For EEPROMS, as is the case with all archival memory, cycle life plays an important role in consumer confidence and acceptance. If the cycle life of a memory device is too short, the consumer will be adverse to using this device for fear of losing valuable data. If the EEPROM is to be used as a replacement for computers main memory or display memory, that is, as a replacement for DRAM or SRAM, the requirement of long cycle life is even more critical. The main and display memory are a computer's most often written to/erased data storage area. Every time a new computer program is loaded, a portion of the computer's main memory is erased and rewritten. During the execution of a computer program, a portion of the computer's main memory is constantly being cycled. Every time the computer monitor's display is changed, portions of the display memory are cycled. If the EEPROMs used to replace the computer's main and display memory do not have a relatively long write/erase cycle life, these memories would need to be replaced excessively. This would lead to excessive costs to the consumer and therefore loss of consumer confidence.

### SUMMARY OF THE INVENTION

There is disclosed herein an electrically operated memory element having the features as claimed in claim 1. These fundamentally new solid state, directly overwritable. electronic, non-volatile, high density, low cost, readily manufacturable, single cell memory elements have reduced switching current requirements and greater thermal stability data stored therein. These memory elements utilize a unique class of chalcogenide memory materials which exhibit orders of magnitude higher switching speeds at remarkably reduced energy levels. The novel memory materials, of which the memory elements and arrays of the instant invention are formed, are characterized, inter alia, by stable and truly non-volatile detectable configurations of local atomic and/or electronic order which can be selectively and repeatably established by electrical input signals of varying pulse voltage, current and duration. The memory devices of the instant invention are therefore switchable between atomic and\or electronic configurations of different local order in a single crystalline state so as to provide at least two stable settings. The orders of magnitude of improvement in switching speeds and in switching energies made possible by the memory elements disclosed herein is not merely incremental in nature, but rather represents a fundamental improvement beyond what was previously thought possible.

While theories on the memory materials described herein are presently being investigated, no theory as yet proposed explains all of the extraordinary electrical switching behavior observed. Specifically, the subject semiconductor materials can be switched between numerous electrically detectable conditions in nanosecond time periods with the input of picojoules of energy. The subject memory materials are truly non-volatile and can be cycled (written and rewritten) almost indefinitely while maintaining the integrity of the information stored by the memory cell without the need for periodic refresh signals. The subject memory material is directly overwritable so that information stored in other memory elements need not be erased (as is required with ferroelectric and other flash storage systems) in order to change information stored in a given set of memory elements.

The memory element of the instant invention, includes a volume of memory material defining a single cell memory. The memory material is characterized by a large dynamic range of electrical resistance values and the ability to be set at one of a plurality of resistance values within said dynamic range in response to a selected electrical input signal so as to provide said single cell with multibit storage capabilities. A pair of spacedly disposed contacts are provided for supplying said electrical input signal to set said memory material to a selected resistance value within the dynamic range and the single cell of memory material is setable, by said selected electrical signal to any resistance value in said dynamic range, regardless of the previous resistance value of said material.

The instant invention further describes an electrically operated memory array of directly overwritable, multilevel, single cell memory elements. The array includes a substrate and a plurality of electrically activated directly overwritable, multilevel, single cell memory elements spacedly disposed in a plurality of rows and columns on the substrate. Each of the memory elements has an isolation device associated therewith to electrically isolate the element from the remainder of the elements. Each of the single cell memory elements is defined by a volume of memory material. The memory material possesses an energy modulatable Fermi level position, said position characterized by the ability to be modulated over a large range of electrical resistances while maintaining a substantially constant optical band gap. The material is characterized by the ability to be set at one of a plurality of resistance values within the dynamic range in response to a selected electrical input signal so as to provide the cell with multilevel storage capabilities. Each of the memory elements further includes a pair of spacedly disposed contacts for applying an electrical input signal to set said memory material to a selected resistance value within the dynamic range. The contacts serve as terminals for reading from and writing to the memory element. The single cell of memory material is settable, by said selected electrical signal to any resistance value in said dynamic range, and said material is capable of remaining set at said value after the termination of the set signal. Address lines are provided so as to make electrical contact with the volume of memory material and with the isolation device, thereby providing means for selectively and individually setting and reading the resistance values of each discrete memory element.

The instant invention further discloses a method of modulating the position of the Fermi level of a microcrystalline semiconductor material, selected from the group consisting of Se, Te, Ge, Sb, Bi, Pb, Sn, As, S, Si, P, O and mixtures or alloys thereof, relative to a band edge thereof into any one of a plurality of metastable detectable positions. The material is characterized by a large dynamic range of substantially different electrical conductivities corresponding to the Fermi level position and a substantially constant optical band gap throughout the entire range. The method includes the steps of providing a homogeneous body of chalcogenide alloy material, applying an electrical signal to modulate the position of the Fermi level thereof to a selected position so as to obtain a given conductivity value within the dynamic range, and terminating the application of energy to the material while maintaining the position of the Fermi level thereof at substantially the selected position to which it was modulated.

The instant invention further discloses a method of modulating the electrical conductivity of a multi-element composition of microcrystalline semiconductor material, the constituent elements of which are intercoupled to form a lattice structure defining the crystallites of the material. The modulation is accomplished by varying the concentration of free charge contributed by the presence or absence of atoms of at least one of the constituent elements in the composition. The method includes the steps of providing a composition of microcrystalline semiconductor material which includes a volume fraction of crystallites, the crystallites defined by a lattice structure which incorporates atoms of each of the constituent elements in the composition; applying an electrical signal to the material so as to add or subtract charge carriers contributed by said one of the constituent elements in said composition into or out of the lattice structure, whereby the electrical conductivity of the material is modulated to a value which is dependent upon the concentration of free charge contributed by said at least one constituent element; and maintaining (a) the concentration of free charge determined by the application of energy, and (b) the new value of electrical conductivity of the material after terminating the application of the signal to said material.

In an embodiment of the instant invention, an electrically operated, directly overwritable, multilevel, single-cell memory clement is described which includes a volume of memory material defining a single cell memory. The memory elements include a pair of spacedly disposed contacts between which is disposed the volume of memory material. The contacts provide terminals for reading information stored in and writing information to said memory elements. The memory elements also include means for applying said electrical input signal to set said volume of memory material to a selected resistance value. The volume of memory material is formed from a plurality of constituent atomic elements, selected from the group consisting of Te, Ge, Sb, Bi, Pb, Sn, As, S, Si, P, O and mixtures or alloys thereof, each of which is present throughout the entire volume of memory material. The volume of memory material including means for varying the positional composition of said volume of memory material so as to substantially reduce drifting of the resistance thereof from a selected resistance value. This memory material is characterized by a large dynamic range of electrical resistance values and the ability to be set to one of a plurality of resistance values within said dynamic range, regardless of the resistance value to which said memory material was previously set, in response to a selected electrical input signal so as to provide said single cell with multilevel storage capabilities. The memory material remains set at said selected resistance value without drift after the input signal has been terminated. The aforementioned means for varying the positional composition of said volume of memory material may be accomplished by forming the volume of memory material in compositionally graded, layered, and combination graded/layered forms as well as by otherwise compositionally modifying the volume of memory material to yield reduced values of resistance due to drift. Of course, this has been accomplished in a manner which can also accommodate a means of changing the band gap, altering the lattice stress or otherwise changing the atomic or electronic motion of electrons, including the lone pair electrons.

In another embodiment of the instant invention, a directly overwritable, single-cell memory element is described which includes a volume of memory material. The memory element includes a pair of spacedly disposed contacts between which is disposed the volume of memory material. The contacts include a thin-film layer of silicon disposed adjacent the volume of memory material so as to provide terminals for reading information stored in and writing information to said memory elements. The memory elements also include means for applying said electrical input signal to set said volume of memory material to a selected resistance value. The volume of memory material is formed from a plurality of constituent atomic elements including a chalcogen of Se, Te and mixtures or alloys thereof, and is characterized by having at least two detectable values of electrical resistance and the ability to be set to one of a the detectable resistance values, regardless of the resistance value to which said memory material was previously set, in response to a selected electrical input signal. The memory material remains set at said selected resistance value without drift after the input signal has been terminated.

Other embodiments and features of the present invention as well as other advantages and objects thereof will be set forth and become apparent from the detailed description of the invention which follows hereinafter, especially when taken in combination with the accompanying drawings.

### BRIEF DESCRIPTION OF THE DRAWINGS

Fig. 1 is a fragmentary cross-sectional view illustrating a portion of an integrated circuit, said circuit depicting an electrically erasable and directly overwritable multilevel memory configuration of a first preferred embodiment of the present invention;
Fig. 2 is a fragmentary cross-sectional view illustrating a portion of an integrated circuit, said circuit depicting an electrically erasable and directly overwritable multilevel memory configuration of a second preferred embodiment of the present invention;
Fig. 3 is a top plan view schematically illustrating a portion of the integrated circuit configurations of Figs. 1 and 2;
Fig. 4 is a schematic circuit diagram illustrating a portion of the X-Y matrix array of isolation elements in combination with the memory elements of the integrated circuit configurations of Figs. 1 and 2;
Fig. 5 is a schematic representation illustrating a single crystal semiconductor substrate with the integrated memory matrix of the instant invention as depicted in Figs. 1 and 2 placed in electrical communication with an integrated circuit chip on which the address/drivers/decoders are operatively affixed;
Fig. 6 is a graphical representation in which device resistance is plotted on the ordinate and signal pulse voltage is plotted on the abscissa, said graph illustrating the multilevel storage capabilities of single memory cell elements of the instant invention;
Fig. 7 is a tabular representation of data taken on the novel semiconductor material of the present invention comparing the electrical and optical properties for the amorphous and the different crystalline phases of said material;
Fig. 8 is a ternary phase diagram of the Ge:Sb:Te alloy system from which the memory elements of the instant invention are fabricated, said phase diagram showing the multiple phases into which various mixtures of these elements segregate upon rapid solidification;
Fig. 9 is a graphical representation of cycle life data taken on the improved memory elements of the instant invention and particularly depicting the stable set resistance with respect to cycle history; and in which electrical resistance is plotted on the ordinate and set pulse voltage is plotted on the abscissa;
Fig. 10 depicts the atomic structural layering of three ternary alloys of the Ge-Sb-Te system of Fig. 7 as well as the atomic structure of binary Ge-Te so as to illustrate the anisotropic structure of the systems;
Figs. 11a, 11b and 11c are three dimensional graphs depicting device resistance (in kohms) as a function of set pulse amplitude (in mA) and one of pulse rise time, pulse fall time or pulse width (in nsec), respectively;
Figs. 12a and 12b are graphical representations of memory elements which have and have not, respectively, been compositionally modified to reduce set resistance value drift, and in which electrical resistance is plotted on the ordinate and elapsed time (since setting the memory element) is plotted on the abscissa;
Fig. 13 is a graphical representation of data taken for a memory element including a volume of memory material having a nominal chemical composition of (Te₅₆Ge₂₂Sb₂₂)₉₀Ni₅Se₅ without the structural modification of the instant invention, specifically depicted is the device resistance plotted on the ordinate versus the write/erase cycle number plotted on the abscissa;
Fig. 14 is a graphical representation of data taken for a memory element including a volume of memory material having a nominal chemical composition of (Te₅₆Ge₂₂Sb₂₂)₉₀Ni₅Se₅ having the improved structure of the instant invention, specifically depicted is the device resistance plotted on the ordinate versus the write/erase cycle number plotted on the abscissa; and
Fig. 15 is a graphical representation of data taken for a memory element including a volume of memory material having a nominal chemical composition of (Te₅₆Ge₂₂Sb₂₂)₉₀Ni₅Se₅ (i.e. the modified material) and a memory element including a volume of memory material having a nominal chemical composition of Te₅₆Ge₂₂Sb₂₂ (i.e. the standard material), specifically depicting data retention time plotted on the ordinates versus device temperature (or a function thereof) on the abscissas.

### DETAILED DESCRIPTION OF THE INVENTION

Erasable electrical memories fabricated from the broad class of chalcogenide materials have employed structural changes that were accommodated by movement of certain atomic species within the material to permit change of phase as the material switched from the amorphous state to the crystalline state. For example, in the case of electrically switchable chalcogenide alloys formed of tellurium and germanium, such as those comprising about 80% to 85% tellurium and about 15% germanium along with certain other elements in small quantities of about one to two percent each, such as sulfur and arsenic, the more ordered or crystalline state was typically characterized by the formation of a highly electrically conductive crystalline Te filament within the switchable pore of the memory material. A typical composition of such a prior art material would be, for example, Te₈₁Ge₁₅S₂As₂ or Te₈₁Ge₁₅S₂Sb₂. Because Te is so highly conductive in its crystalline state, a very low resistance condition was established through the Te filament in the more ordered or crystalline state; this resistance being a number of orders of magnitude lower than the resistance of the pore in the less ordered or amorphous state.

However, the formation of the conductive Te filament in the crystalline state required migration of the Te atoms from their atomic configuration in the amorphous state to the new locally concentrated atomic configuration in the crystalline Te filament state. Similarly, when the chalcogenide filamentary material was switched back to the amorphous state, the Te which had precipitated out into the crystalline filament was required to migrate within the material from its locally concentrated form in the filament back to its atomic configuration in the amorphous state. This atomic migration, diffusion or rearrangement between the amorphous and crystalline states required in each case a holding or dwell time of sufficient length to accommodate the migration, thereby making the requisite switching time and energy relatively high.

The subject inventors have now discovered a remarkable reduction in both the required switching time and the energy input for a fundamentally different type of electrically erasable, directly overwritable memory based up on a new class of chalcogenide semiconductor materials. Moreover, the chalcogenide materials of the instant invention are based on fundamentally new physics, the operation of which, although not fully understood, provides for switching either within a wide dynamic range of stable states within a given crystalline lattice structure or between different crystalline states with remarkably low energy inputs at remarkably fast speeds so that this newly discovered class of materials can be used to fabricate improved electrical memory elements. In operation, these novel materials are based upon the ability to create a very high, non-volatile and modulatable concentration of free charge in narrow band gap semiconductor material in which the band gap can be tailored. These materials are different than conventional amorphous and crystalline materials in that the crystallites can resemble the more disordered state and heavily influence the electronic conductivity of the switch.

Specifically, the memory material of the present invention can be switched between electrically detectable conditions of varying resistance in nanosecond time periods (the minimum switching speed and minimum energy requirements have not as yet been ascertained, however, experimental data as of the filing of this application have shown that the electrical memory of the instant invention can be modulated (even though not optimized) with as short as 1 nanosecond programming pulses) with the input of picojoules of energy. This memory material is non-volatile and will maintain the integrity of the information stored by the memory cell (within a selected margin of error) without the need for periodic refresh signals. In contrast to many other semiconductor materials and systems heretofore specified for memory applications, the semiconductor memory material and systems of the present invention are directly overwritable so that the discrete memory elements need not be erased (set to a specified starting point) in order to change information stored there. The remarkably fast and low energy switching to any of the different values of resistance can be attributed to the fact that said switching occurs without the need for gross atomic rearrangement of the switching material. Our current understanding suggests that the memory material is present in a microcrystalline phase and experimental evidence also demonstrates the existence of some correspondence between crystallite size of the microcrystalline semiconductor material and the ability of that material to quickly assume other stable states upon the application of a low energy signal.

Although specific examples of semiconductor materials adapted for, *inter alia*, memory usage are described below, the memory element of the present invention can be fabricated from any body of semiconductor material which meets the requirement of modulatable free charge concentration by shifting the Fermi level position relative to a band edge. Particularly, for the newly discovered family of semiconductor materials as applied to electrical memories, the result is high-speed, low-energy, direct-overwrite operation. The memory material is formed from a plurality of constituent atomic elements, each of which is present throughout the entire volume of memory material. The plurality of constituent atomic elements includes at least one chalcogen element and may include at least one transition metal element. The term "transition metal" as used herein includes elements 21 to 30, 39 to 48, 57 and 72 to 80. More preferably, the plurality of constituent atomic elements which form the volume of memory material includes elements selected from the group consisting of Te, Se, Ge, Sb, Bi, Pb, Sn, As, S, Si, P, O and mixtures or alloys thereof. More preferably the transition metal includes Cr, Fe, Ni and mixtures of alloys thereof and the chalcogen element includes Te and Se. Most preferably the transition metal is Ni. Specific examples of such multi-element systems are set forth hereinafter with respect to the Te:Ge:Sb system with or without Ni and/or Se.

As is well known to those skilled in the art, chalcogenide semiconductor materials, like other semiconductors, are characterized by a forbidden energy zone or band gap separating their conduction and valence bands (see the "Cohen, Fritzsche, Ovshinsky model" describing the mobility gap of chalcogenide semiconductor materials). The Fermi level position, i.e., the energy at which the probability of occupancy of an energy level is 50%, determines, in part, the electrical conductivity of the semiconductor material and, as it is moved to substantially different positions in the band gap, a large dynamic range of electrical conductivities become possible. However, previously hypothesized theories can neither explain the very low energy requirements needed to change the position of the Fermi level and thereby set the memory elements at a given resistance value nor can they explain the types of results presented graphically below, particularly the remarkable ability to move to intermediate values of resistance in both directions (from values of lesser resistance to values of greater resistance upon the input of a given electrical signal as well as visa versa) without returning to the aforementioned initial "starting state" which requires operation only in a single direction of movement (from values of higher resistance to values of lower resistance). That is why we state that the semiconductor material of the instant invention is truly directly overwritable. Regardless of the explanation of the manner in which this is accomplished, the present invention provides a combination of valuable electrical switching characteristics never before available in a single memory element. It must be pointed out that experimental results have demonstrated that the chalcogenide compositions, investigated to date, employ hole conduction and when used for multilevel data storage operation, input signals can move the Fermi level position from a position in midgap to the valence band edge and even to a point deeper into the valence band. As a matter of fact, it appears that the dynamic range is present within the valence band.

A fundamental rule distinguishing noncrystalline solids from their crystalline counterparts is that the constituent atoms of the non-crystalline phases have bonding options. This is the sine qua non of noncrystalline solids. It results from the fact that crystalline symmetry prescribes the lattice which, in turn, restricts chemical bonding choices. All of the properties possessed by an amorphous solid; its cohesive energy, its resistance to crystallization, its optical band gap, its mobility gap, its density of electronic states, etc., depend upon three factors; its short range bonding relationships, its varied topological configurations, and its total interactive environment. An amorphous material, however, can be a nonstoichiometric alloy in a nonequillibrium configuration, consisting of many different types of atoms, providing a variety of local order and environments. The crystallites from which a large volume fraction of the semiconductor material of the instant invention is composed, are very small, on the order of (by way of example 50 nm (500 Angstroms) in major dimension. These crystallites are surrounded by a skin or surface region of structurally disordered material which may only be a few atomic monolayers thick. Therefore, an amorphous model or at least a model characterized by only short range local order, can best be employed to attempt to predict the molecular and atomic interactions in the surface region. Without wishing to be bound thereby, such a descriptive model will be described in the following paragraphs.

The specific semiconductor alloys employed in fabricating the memory devices include chalcogenide elements which are particularly noted for the presence of "lone pair" electrons. It is therefore necessary to discuss the effect of those lone pair electrons in available chemical bonding configurations. Simply stated, a lone pair is a pair of electrons in the valence shell of an atom that is typically not engaged in bonding. Such lone pair electrons are important both structurally and chemically. They influence the shape of molecules and crystalline lattice structures by exerting strong repulsive forces on neighboring electron pairs which are engaged in bonding configurations and as well as on other lone pairs. Since lone pair electrons are not tied down into a bonding region by a second nucleus, they are able to influence and contribute to low energy electronic transitions. As first pointed out by Ovshinsky, the lone pairs can have 1 and 3 center bonding; and as demonstrated by Kastner, Adler and Fritsche, they have valance alternation pairs.

Specifically, the tellurium alloys described herein have a valence band made up of lone pair states. Since four (4) p shell electrons are present in Te, and the Te atom is chemically bonded by two of these bonding electrons in the p shell, the other two outer electrons (the lone pair) are not utilized for bonding purposes and hence do not substantially change the atomic energy of the system. In this regard, note that the highest filled molecular orbital is the orbital which contains the lone pair electrons. This is significant because, in a perfect stoichiometric crystal of tellurium and germanium atoms, upon the application of some internal strain in the lattice from which the crystallite is formed, the valence band can broaden and move upward toward the position of the then existing Fermi level. However, TeGe crystals are naturally "self-compensated", that is, the crystal desires to preferentially assume a Te rich (52 percent Te and 48 percent Ge) composition. The stoichiometric crystal is a face centered cube; however, with the addition of a minimal amount of energy, the crystal can assume a rhombohedral lattice structure by increasing the number of its Ge and/or Sb vacancies. It is this creation of vacancies in the crystalline lattice structure, which can reduce lattice strain in TeGe alloys, is responsible for lowering the energy state of the material and moves the Fermi level toward the valence band.

Although we have only demonstrated the existence of stable intermediate values of resistance in the rhombohedral crystal structure, the system is microcrystalline in which the grain size is very small and the surface skin may play a very significant role. It is therefore acceptable, if not essential to superimpose an amorphous model of local order on top of a short range local order model for the purpose of obtaining a descriptive, if not perfectly predictive explanation of atomic behavior. When considering the amorphous nature of the material, note that the density of defect states in the band tails is greatest adjacent the band edges, while the depth of the recombination centers for captured charge carriers are deeper farther away from the band edges. The presence of these deep traps and tail states would provide a possible explanation for intermediate stable resistance values between the Fermi level position and the band edge. Regardless of theory, the semiconductor material of the instant invention is a degenerate semiconductor which exhibits metallic-like conduction.

It is further believed that the size of the crystallites which exist in the bulk of the semiconductor and memory material is relatively small, preferably less than about 200 nm (2000 **Å**) more preferably between about 5 and 50 nm (50 and 500 **Å**) and most preferably on the order of about 20 to about 40 nm (200 to about 400 **Å**). Further, these crystallites are believed to be surrounded by an amorphous skin which may contribute to the rapid formation of the many Fermi level positions of the material, detectable as different resistances (conductivities), as well as to the lower energy requirements for the transitions between these detectable resistance values to which the material can be reliably and repeatably set.

In accordance with still another aspect of the present invention, it has been found that modulation of the switching characteristics of two or three terminal semiconductor devices fabricated from the microcrystalline materials of the present invention may be controlled such that repeatable and detectable resistance values can be effected. It has been found that, in order for the materials of the present invention to be quickly set by low energy input signals to a desired conductivity (determined by the Fermi level position), it is only necessary that said materials are capable of stable (or long lived metastable) existence with at least two different Fermi level positions, which Fermi level positions are characterized by substantially constant band gaps but different electrical conductivities.

As noted above, it is also believed that the relatively small crystallite size may contribute to the rapid transition between detectable values of resistance. It has now been postulated that a microcrystalline lattice structure switches more rapidly between these resistance values because the microstructures can be readily adjusted on an atomic level. For instance, when the lone pair electrons which are responsible for the rapid switching, bonds with the Ge or Sb atoms do not have to be broken by the electrical pulse in order to provide for increased electrical conductivity.

One characteristic of the semiconductor materials of the present invention is their tendency toward the formation of more and smaller crystallites per unit volume. Crystallite sizes of the widest preferential range of representative materials embodying the present invention have been found to be far less than about 200nm (2000 **Å**) and generally less than the range of about 200 to 500nm (2,000 to 5,000 **Å**) which was characteristic of prior art materials. Crystallite size is defined herein as the diameter of the crystallites, or of their "characteristic dimension" which is equivalent to the diameter where the crystallites are not spherically shaped.

It has been determined that compositions in the highly resistive state of the class of TeGeSb materials which meet the criteria of the present invention are generally characterized by substantially reduced concentrations of Te relative to that present in prior art electrically erasable memory materials. In one composition that provides substantially improved electrical switching performance characteristics, the average concentration of Te in the as deposited materials was well below 70%, typically below about 60% and ranged in general from as low as about 23% up to about 58% Te and most preferably about 48% to 58% Te. Concentrations of Ge were above about 5% and ranged from a low of about 8% to about 40% average in the material, remaining generally below 50%. The remainder of the principal constituent elements in this composition was Sb. The percentages given are atomic percentages which total 100% of the atoms of the constituent elements. Thus, this composition may be characterized as TeₐGe_{b}Sb_{100-(a+b)}. These ternary Te-Ge-Sb alloys are useful starting materials for the development of additional memory materials having even better electrical characteristics.

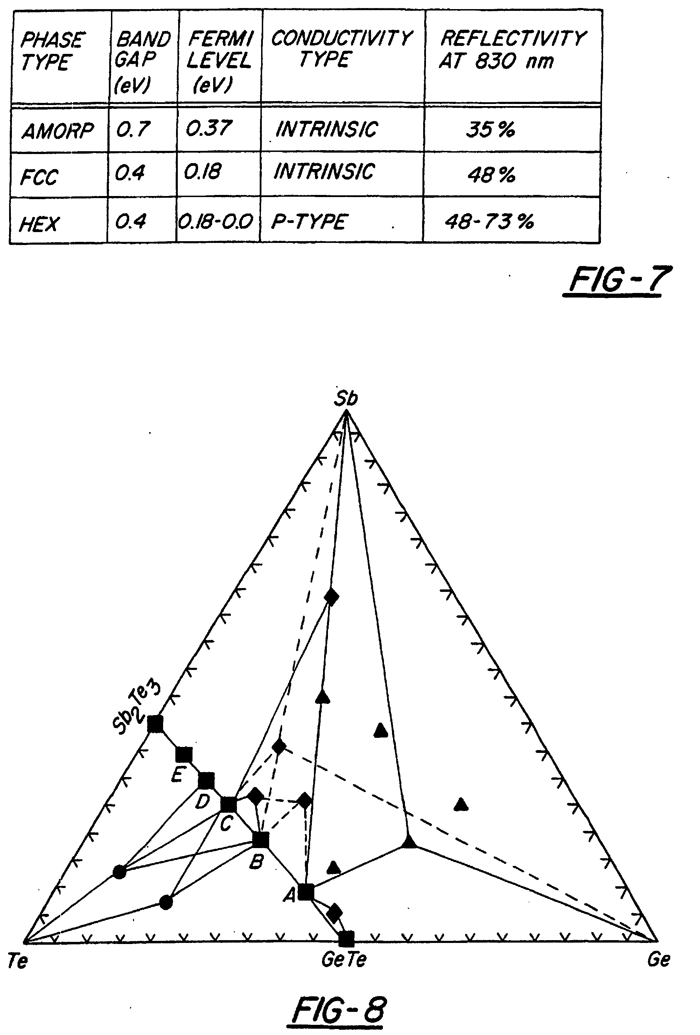

A ternary diagram of the Te:Ge:Sb system is shown in Fig. 8. Melts were prepared from various mixtures of Te, Ge and Sb, the melts segregated into multiple phases upon rapid solidification. Analysis of these rapidly solidified melts indicated the presence of ten different phases (not all present in any one rapidly solidified melt). These phases are: elemental Ge, Te and Sb, the binary compounds GeTe, and Sb₂Te₃ and five different ternary phases. The elemental compositions of all of the ternary phases lie on the pseudobinary GeTe-Sb₂Te₃ line and are indicated by the reference letters A, B, C, D and E on the ternary diagram shown in Fig. 8. The atomic ratios of the elements in theses five ternary phases are set forth in Table 1. A more detailed description of Fig. 8 is presented hereinbelow.

**Table I**

| Observed Ternary Crvstalline Phases of the TeGeSb System | | | |
|---|---|---|---|
| Designation | At % Ge | At % Sb | At % Te |
| A | 40 | 10 | 50 |
| B | 26 | 18 | 56 |
| C | 18 | 26 | 56 |
| D | 14 | 29 | 57 |
| E | 8 | 35 | 56 |

The novel memory elements of the present invention include a volume of memory material, said memory material including at least one chalcogen and can include one or more transition metals. The memory materials which include transition metals are elementally modified forms of our memory materials in the Te-Ge-Sb ternary system. That is, the elementally modified memory materials constitute modified forms of the Te-Ge-Sb memory alloys. This elemental modification is achieved by the incorporation of transition metals into the basic Te-Ge-Sb ternary system, with or without an additional chalcogen element, such as Se. Generally the elementally modified memory materials fall into two categories.

First is a memory material which includes Te, Ge, Sb and a transition metal, in the ratio (TeₐGe_{b}Sb_{100-(a+b)})_{c}TM_{100-c} where the subscripts are in atomic percentages which total 100% of the constituent elements, wherein TM is one or more transition metals, a and b are as set forth herein above for the basic Te-Ge-Sb ternary system and c is between about 90 and about 99.5 %. The transition metal can preferably include Cr, Fe, Ni and mixtures of alloys thereof. Specific examples of memory materials encompassed by this system would include (Te₅₆Ge₂₂Sb₂₂)₉₅Ni₅, (Te₅₆Ge₂₂Sb₂₂)₉₀Ni₁₀, (Te₅₆Ge₂₂Sb₂₂)₉₅Cr₅, (Te₅₆Ge₂₂Sb₂₂)₉₀Cr₁₀, (Te₅₆Ge₂₂Sb₂₂)₉₅Fe₅, (Te₅₆Ge₂₂Sb₂₂)₉₀Fe₁₀, (Te₅₆Ge₂₂Sb₂₂)₉₀Ni₅Cr₅, (Te₅₆Ge₂₂Sb₂₂)₉₀Ni₅Fe₅, (Te₅₆Ge₂₂Sb₂₂)₉₀Cr₅Fe₅, etc.

Second is a memory material which includes Te, Ge, Sb, Se and a transition metal, in the ratio (TeₐGe_{b}Sb_{100-(a+b)})_{c}TM_{d}Se_{100-(c+d)} where the subscripts are in atomic percentages which total 100% of the constituent elements, TM is one or more transition metals, a and b are as set forth hereinabove for the basic Te-Ge-Sb ternary system, c is between about 80 and 99% and d is between about 0.5 and 10%. The transition metal can preferably include Cr, Fe, Ni and mixtures of alloys thereof. Specific examples of memory materials encompassed by this system would include (Te₅₆Ge₂₂Sb₂₂)₉₀Ni₅Se₅, (Te₅₆Ge₂₂Sb₂₂)₉₀Ni₁₀Se₁₀, (Te₅₆Ge₂₂Sb₂₂)₉₀Cr₅Se₅, (Te₅₆Ge₂₂Sb₂₂)₈₀Cr₁₀Se₁₀, (Te₅₆Ge₂₂Sb₂₂)₉₀Fe₅Se₅. (Te₅₆Ge₂₂Sb₂₂)₈₀Fe₁₀Se₁₀, (Te₅₆Ge₂₂Sb₂₂)₈₅Ni₅Cr₅Se₅, (Te₅₆Ge₂₂Sb₂₂)₈₀Ni₅Fe₅Se₁₀, (Te₅₆Ge₂₂Sb₂₂)₈₅Cr₅Fe₅Se₅, etc.

The memory elements of the instant patent application possess substantially non-volatile set resistance values. However, if the resistance value of the instant memory elements does, under some circumstances, drift from its original set value, "compositional modification", described hereinafter, may be used to eliminate for this drift. As used herein, the term "non-volatile" will refer to the condition in which the set resistance value remains substantially constant for archival time periods. Of course, software (including the feedback system discussed hereinafter) can be employed to insure that absolutely no "drift" occurs outside of a selected margin of error. Because drift of the resistance value of the memory elements can, if left unimpeded, hinder gray scale storage of information, it is desirable to minimize drift.

"Compositional modification" is defined herein to include any means of compositionally modifying the volume of memory material to yield substantially stable values of resistance, including the addition of band gap widening elements to increase the inherent resistance of the material. One example of compositional modification is to include graded compositional inhomogeneities with respect to thickness. For instances, the volume of memory material may be graded from a first Te-Ge-Sb alloy to a second Te-Ge-Sb alloy of differing composition. The compositional grading may take any form which reduces set resistance value drift. For example, the compositional grading need not be limited to a first and second alloy of the same alloy system. Also, the grading can be accomplished with more than two alloys. The grading can be uniform and continuous or it can also be non-uniform or non-continuous. A specific example of compositional grading which results in reduced resistance value drift includes a uniform and continuous grading of Ge₁₄Sb₂₉Te₅₇ at one surface to Ge₂₂Sb₂₂Te₅₆ at the opposite surface.

Another manner of employing compositional modification to reduce resistance drift is by layering the volume of memory material. That is, the volume of memory material may be formed of a plurality of discrete, relatively thin layers of differing composition. For example, the volume of memory material may include one or more pairs of layers, each one of which is formed of a different Te-Ge-Sb alloy. Again, as was the case with graded compositions, any combination of layers which results in substantially reduced resistance value drift can be employed. The layers may be of similar thickness or they may be of differing thickness. Any number of layers may be used and multiple layers of the same alloy may be present in the volume of memory material, either contiguous or remote from one another. Also, layers of any number of differing alloy composition may be used. A specific example of compositional layering is a volume of memory material which includes alternating layer pairs of Ge₁₄Sb₂₉Te₅₇ and Ge₂₂Sb₂₂Te₅₆.

Yet another form of compositional inhomogeneity to reduce resistance drift is accomplished by combining compositional grading and compositional layering. More particularly, the aforementioned compositional grading may be combined with any of the above described compositional layering to form a stable volume of memory material. Exemplary volumes of memory material which employ this combination are: (1) a volume of memory material which includes a discrete layer of Ge₂₂Sb₂₂Te₅₆ followed by a graded composition of Ge₁₄Sb₂₉Te₅₇ and Ge₂₂Sb₂₂Te₅₆ and (2) a volume of memory material which includes a discrete layer of Ge₁₄Sb₁₉Te₅₇ and a graded composition of Ge₁₄Sb₂₉Te₅₇ and Ge₂₂Sb₂₂Te₅₆.

Referring now to Fig. 1, there is shown a cross-sectional view of a portion of the structure of an electrically erasable memory of the present invention formed on a single crystal silicon semiconductor wafer 10 which is p-doped and which forms a p-substrate for the deposition of the remaining elements of the configuration illustrated. Formed in the p-substrate 10 are n+ channels 12, which may be diffusion doped in a manner well known in the art. These n+ channels extend across the chip in a direction perpendicular to the plane of the illustration and form one set of electrodes, in this case the y set, of an x-y electrode grid for addressing the individual memory elements.

A top of this n+ grid structure is formed an n-doped crystalline epitaxial layer 14 about 500 nm (5.000 Å) thick. Using known masking and doping techniques, p-doped isolation channels 16 are then formed in the n-epitaxial layer 14. These p-doped isolation channels 16 extend all the way down to the p substrate 10 as shown in Fig. 1 and also extend completely around and isolate and define islands 18 of the n-epitaxial layer 14. The islands 18 are shown more clearly in the top view of Fig. 2 wherein, the p isolation channels are shown as forming an isolation grid defining and isolating the islands 18 of n epitaxial material. Instead of the p-doped isolation channels, SiO₂ isolation trenches may be used for isolation of the islands 18. The technique of formation of such SiO₂ isolation trenches is well known to those skilled in the art. A layer 20 of thermally grown SiO₂ is then formed on the structure just described and etched to form apertures 22 over the islands 18. Diffusion regions 24 of p+ material are then formed within the areas defined by the apertures 22 as shown in Fig. 1. The semiconductor junctions of the p+ regions and the n epitaxial layer define p-n junction diodes 26 in series with each of the regions of the n epitaxial layer exposed through the apertures 22 of the SiO₂ layer 20.

The memory elements 30 are then deposited over the p+ regions 24 in individual ohmic electrical series contact with the diodes 26. The memory elements 30 comprise bottom thin electrical contact layers of high corrosion resistance metal (such as, for example, molybdenum) 32. Previously, in the Ovonic EEPROM, single layers of electrically conductive amorphous carbon were used as diffusion barrier layers 34 and 38; however, in the structurally modified memory elements of the instant invention these a-carbon layers have been modified or replaced. This modified structure includes either a single amorphous silicon layer in place of the amorphous carbon layer or a thin silicon layer disposed between the amorphous carbon layer and the layer of memory material 36. The upper thin electrical contact layer of corrosion resistance material 40 is fabricated of molybdenum and the electrically conductive diffusion barrier layer 38 is fabricated of a-carbon, a-silicon or a dual a-carbon/a-silicon structure. The contact layers 32, 34, 38 and 40 form excellent electrical contacts with the layers of memory material 36 and layers 34 and 38 also form diffusion barriers which inhibit diffusion of the molybdenum metal and/or an optional external contact grid material contact into the volume of chalcogenide memory material 36. The a-sliicon of layers 34 and 38, when used in combination with a-carbon are relatively thin, typically in the range of 5 to 60nm (50 to 600 **Å**) and more particularly 10 to 40 nm (100 to 400 **Å**). When used alone as layers 34 and 38, the a-silicon layers are between about 40 to 200 nm (400 and 200 **Å**) depending on the electrical resistivity thereof. The molybdenum layers 32 and 40 are relatively thick, in the range of about 100 to 200nm (1.000 to 2,000 **Å**)

The layer of memory material 36 is formed of a multi-element semiconductor material, such as the chalcogenide materials disclosed herein. The layer 36 may be deposited by methods such as sputtering, evaporation or by chemical vapor deposition (CVD), which may be enhanced by plasma techniques such as RF glow discharge. The chalcogenide memory materials of the instant invention are most preferably made by RF sputtering and evaporation. Typical deposition parameters for RF sputtering and evaporation of the chalcogenide layer 36 are set forth below in Tables 2 and 3, respectively.

**Table 2**

| RF Sputtering Deposition Parameters | |
|---|---|
| Parameter | Typical Range |
| Base pressure | 8x10⁻⁷ - 1x10⁻⁶ Torr |
| Sputtering gas (Ar) pressure | 4 - 8 m Torr |
| Sputtering power | 40 - 60 watts |
| Frequency | 13 - 14 MHz |
| Deposition Rate | 0,05-0,1 nm/s (0.5 - 1 **Å**/second) |
| Deposition Time | 20 - 25 minutes |
| Film Thickness | 75-125 nm (750 - 1250 **Å**) |
| Substrate Temp. | Ambient - 300°C |

**Table 3**

| Evaporation Deposition Parameters | |
|---|---|
| Parameter | Typical Range |
| Base pressure | 1x10⁻⁶ - 5x10⁻⁶ Torr |
| Evaporation Temp. | 450 - 600 °C |
| Deposition Rate | 0,05-0,35 nm/s (0.5 - 3.5 **Å**/second) |
| Deposition Time | 3 - 20 minutes |
| Film Thickness | 75-125 nm (750 - 1250 **Å**) |
| Substrate Temp. | Ambient - 300°C |

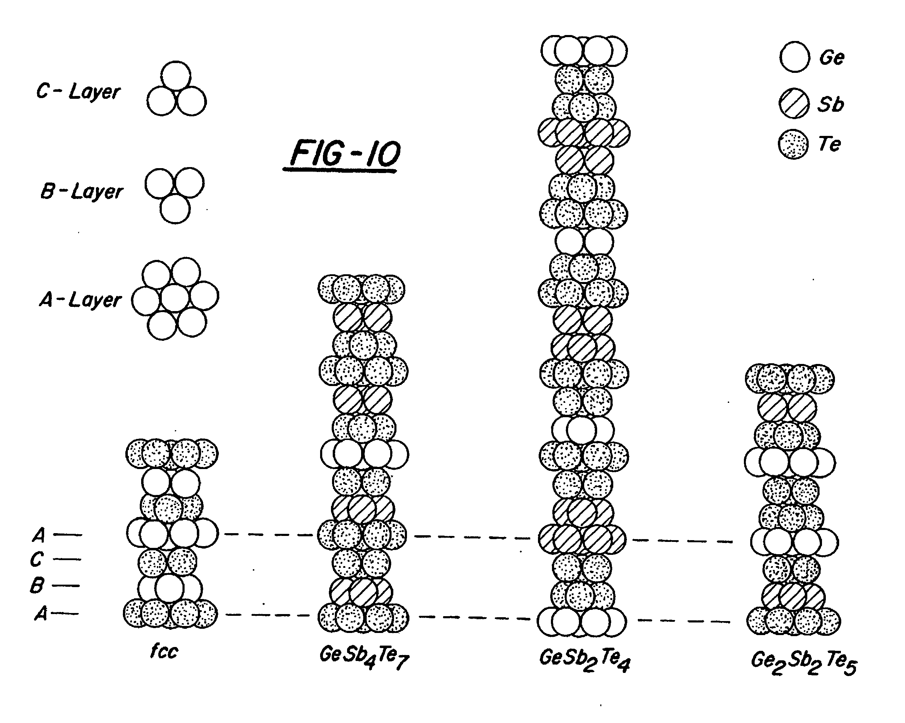

Experimental data obtained by analyzing thin films deposited pursuant to the evaporation parameters set forth in Table 3 demonstrates that the Fermi level position for the fcc phase has been moved adjacent the edge of the valence band (i.e. the fee phase behaves as a semi-metal with zero eV activation energy). Note that the "as deposited" evaporated films are amorphous and subsequently annealed in order to obtain the Fcc lattice structure. In contrast thereto, the Fermi level positions for the hexagonal crystal structure (which is achieved through the input an additional electrical pulse) have been actually moved into the valence band (i.e., the positions exhibit "degenerate semiconductor" or metallic behavior). The reasons for the differences in switching behavior which exist between thin films deposited by sputtering, vis-a-vis, those deposited by evaporation, are not entirely understood. Experimental evidence tends to demonstrate that impurities caused by the presence of oxygen in the sputtered film are responsible for the differences in the Fermi level positions. However, it is noteworthy that oxygen was present in the cathode target material. Its presence was later analytically discovered. It is also important to note that evaporated films deposited on a heated substrate exhibit anisotropic growth characteristics (see the description of Fig. 10) in which oriented layers of the chalcogenide elements are successively deposited. Whether this proves to be significant for electrical applications has yet to be proven; however, this type of film holds promise for thermoelectricity (due to the high thermopower already measured for these compositions, i.e., a factor of four greater than that measured for bismuth systems) or for specific semiconductor and superconductivity applications.

The layer of memory material 36 is preferably deposited to a thickness of about 20 to 500nm (200 **Å** to 5,000 **Å**) more preferably of about 40-250nm (400 **Å** to 2,500 **Å**) and most preferably of about 25-125nm (250 **Å** to 1.250 **Å**) in thickness. The lateral dimension or diameter of the pore of semiconductor material 36 is less than about one to two micrometers or so, although there is no practical limit on the lateral dimension. It has been determined that the diameter of the actual conductive path of the high conductivity material is significantly less than a micrometer. The pore diameter can thus be as small as lithography resolution limits will permit and, in fact, the smaller the pore, the lower the energy requirements for electrical switching.

In a preferred embodiment of the present invention, the pore diameter is selected such that it conforms substantially with the diameter of the low resistance path which is formed when the material is switched to the low resistance state. The diameter of the pore of memory material 36 is therefore preferably less than about one micrometer so that the volume of the memory material 36 is limited, to the extent lithographically possible, to the volume of the material 36 which is actually switched between the various states of resistance. This further reduces the switching time and the electrical energy required to initiate the detectable change in resistance. The term "pore diameter" as used herein shall mean the lateral cross-sectional dimension of the layer of memory material 36 which extends under the contact regions formed with the memory layer 36 and with the lower p+ layer and the upper conductors 42 as shown in the embodiment of Fig. 1. It is further preferred that the pore regions of the memory elements 30 be thermally isolated and/or controlled except for such electrical contact with the upper and lower electrodes as is necessary for proper operation of the memory elements. This further confines, limits and controls the heat transfer from the switched volume of the pore and the electrical energy required for the resistance transitions. This is accomplished in the embodiment of Fig. 1 by the oxide layers 20 and 39 which surround the lateral periphery of the memory elements 30. Accordingly, in order to minimize set energy/ current/ voltage, small pore diameters of as low as 25nm (250 **Å**) may be employed.

The layers 32, 34, 36, 38 and 40 are etched and an oxide layer 39 is formed thereover and etched to leave openings above the memory elements 30 as shown. Alternatively, the memory elements may be formed in a two step etch process with layers 32 and 34 being first deposited and then etched over the top of which the remaining layers 36, 38 and 40 are deposited and then separately etched to the selected dimension. Deposited on top of the entire structure formed by layers 32, 34, 36, 38, and 40 is the second electrode grid structure formed of aluminum conductors 42, which extend perpendicular in direction to the conductors 12 and complete the x-y grid connection to the individual memory elements. Overlaying the complete integrated structure is a top encapsulating layer 44 of a suitable encapsulant such as Si₃N₄ or a plastic material such as polyamide, which seals the structure against moisture and other external elements which could cause deterioration and degradation of performance. The Si₃N₄ encapsulant can be deposited, for example, using a low temperature plasma deposition process. The polyamide material can be spin deposited and baked after deposition in accordance with known techniques to form the encapsulant layer 44.

It is important to note that conventional CMOS technology cannot be used to produce this type of three dimensional memory array since CMOS technology builds the required semiconductor devices into the bulk of single crystal semiconductor wafers and, therefore, can only be used to fabricate a single layer of devices. Furthermore, (**1**) CMOS cannot produce a small enough footprint (actual element dimension) to cost effectively produce large arrays and (**2**) CMOS devices, because they exist in a single plane, cannot be interconnected along the Z direction. Therefore, CMOS devices cannot be fabricated with the complex, three-dimensional interconnectivity required for advanced parallel processing computers. The three-dimensional, thin-film memory array structures of the instant invention, on the other hand are capable of both conventional serial information processing as well as parallel information processing.

Parallel processing and therefore multidimensional memory array structures are required for rapid performance of complex tasks such as pattern recognition, classification or associative learning etc. Further uses for and description of parallel processing are presented in U.S. Patent application Serial No. 594,387, filed October 5, 1990, which is assigned to the assignee of the instant application. With the integrated structure as shown in the embodiment of Fig. 1; however. a completely vertically integrated structure of the memory element and its isolating diode is formed, thus minimizing the area occupied on the substrate by each of the combinations of memory elements and diodes. This means that the density of the memory elements in the chip is limited essentially only by the resolution capabilities of the lithography.

The embodiment of Fig. 2 is the same as Fig. 1 except that a diode 27 is formed as a Schottky barrier operatively disposed between the n layer 14 and a metal layer 29 which may be, for example, platinum silicide. In other respects, the structural embodiment of memory cell/isolation element depicted in Fig. 2 is formed in the same manner as that of Fig. 1 and like elements are labeled with like reference numerals.

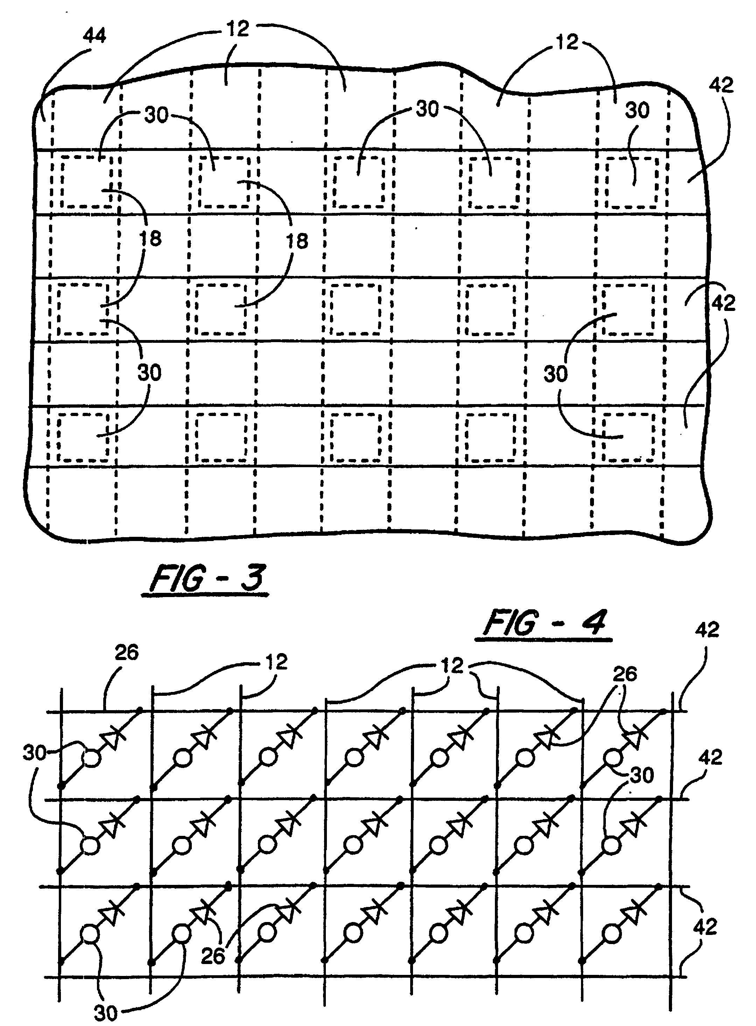

The integrated structure thus formed is an x-y memory matrix connected as shown in Fig. 3 in which each memory element 30 is connected in series with a diode 26 between a horizontal x-line 42 and a vertical y-line 12. The diodes 26 serve to electrically isolate each of the memory elements 30. Other circuit configurations for the electrically erasable memory of the present invention are, of course, possible and feasible to implement. One particularly useful configuration is a three dimensional, multilevel array in which a plurality of planes of memory or condol elements and their respective isolation devices are stacked upon one another. Each plane of memory elements is arranged as a plurality of rows and columns of memory elements, thereby allowing for X-Y addressing. This stacking of planes, in addition to increasing memory storage density, allows for an additional Z dimension of interconnection. This arrangement is particularly useful to simulate a neural network for a truly intelligent computer.

Fig. 4 is a stylized, schematic circuit diagram of a portion of the memory cell embodiments of Fig. 1. The circuit comprises an x-y grid with each of the memory elements 30 being electrically interconnected in series with an isolation diode 26 at the cross points of the x address lines 42 and the y address lines 12 as shown. The address lines 12 and 42 are connected to external addressing circuitry in a manner well known to those skilled in the art. The purpose of the x-y matrix of memory elements in combination with isolation elements is to enable each one of the discrete memory elements to be read and written without interfering with information stored in adjacent or remote memory elements of the matrix.

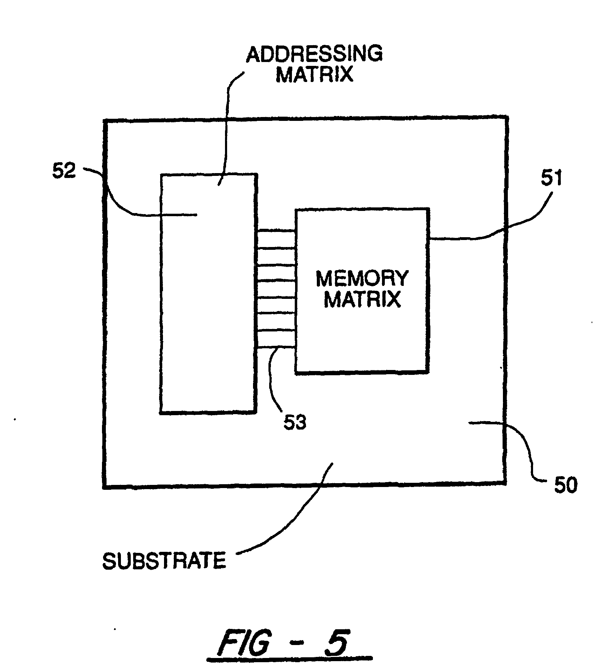

In Fig. 5, there is diagrammatically illustrated a portion of a single crystal semiconductor substrate 50 with a memory matrix 51 of the present invention formed thereon. Also formed on the same substrate 50 is an addressing matrix 52 which is suitably connected by integrated circuitry connections 53 to the memory matrix 51. The addressing matrix 52 includes signal generating means which define and control the setting and reading pulses applied to the memory matrix 51. Of course, the addressing matrix 52 may be integrated with and formed simultaneously with the solid state memory matrix 51.

In prior art semiconductor memories having the relatively high switching speeds and low switching energies deemed necessary for most applications thereof, at least one transistor and a capacitor is required for each memory element. The formation of such memories in integrated circuit form requires at least three connections along with other additional complexities which occupy a certain minimum substrate area regardless of how the integrated circuit is laid out. The integrated circuit configuration of the electrically erasable memory of the present invention requires only two connections to each memory element and these can be made in vertical relationship to each other. Further, each memory element, complete with isolating diode and the pair of contacts for the element, is itself fully vertically integrated such that a significantly higher bit density is possible. In fact, the memory of the present invention provides for a bit density which is greater than that attainable even in solid state dynamic random access memories (DRAMs), which are volatile and therefore lack the further advantages that the non-volatility attainable with the present invention provides. The increase in bit density attainable with the present invention translates into a corresponding reduction in manufacturing costs because of the smaller areas of the wafer occupied per bit of the integrated circuit configuration. This allows the memory of the present invention to compete with and surpass other available memories for a wider range of applications, not only in terms of electrical performance and memory storage capacity, but also in terms of cost. By comparison with prior art semiconductor memories formed of at least one transistor and a capacitor for each bit, the integrated circuit configurations of the present invention, as shown in Fig. 1, can be formed on a chip with greater bit density compared to prior art configurations using the same photo lithographic resolution. In addition to the cost advantages that the higher bit density affords, the elements are positioned closer together and lead lengths, capacitances, and other related parameters are further minimized, thereby enhancing performance.

Through the use of the novel semiconductor materials of the instant invention, the energy required to effect a change of Fermi level position and a corresponding change in electrical conductivity has been reduced by orders of magnitude. Further, it is now believed that even the picojoule energies thought to be necessary by the present invention, can be further lowered by reducing the time duration of the electrical pulses. Additionally, reductions in the thickness of the material could further reduce the pulse energy required to set a memory element to a given resistance value.

The following section of the detailed description is intended to explain the manner in which the understanding of the scope of the disclosed discovery has evolved. Crystalline GeTe. grown from the melt, has a rhombohedrally distorted (88.2° instead of a 90° NaCl (i.e. face-centered cubic)) structure at room temperature. This structure changes to a face centered cubic structure above 400°C. The origin of the rhombohedral distortion and, in particular, the relation of that distortion to the concentration of Ge vacancies in the highly conductive p-type GeTe is not clear yet. In this rhombohedrally distorted crystalline state, GeTe exhibits metallic conductivity (≃ 10³-10⁴)(ohm-cm)⁻¹. In thin film form. GeTe can be grown in the amorphous phase and at about 200°C, crystallizes into the face centered cubic structure. This metastable face centered cubic phase is stable at room temperature because of me microcrystalline structure of the films. However, at annealing temperatures above 400°C, the face centered cubic structure changes to the stable hexagonal or rhombohedral structure depending on Sb content.

In the ternary Ge-Sb-Te system, the substitution of Sb for Ge in GeTe results in properties similar to that of a pure GeTe crystal. In bulk form, the stable room temperature phase is the hexagonal phase, but it is believed that it changes to the face centered cubic phase at higher temperatures. When annealed, thin films of the amorphous state first crystallize into the face centered cubic phase at temperatures of about 200°C; however, upon annealing to higher temperature, they change into the hexagonal phase. This structural transition occurs at a temperature that depends on the specific composition of the film. The electrical properties of thin films of amorphous and crystalline Ge-Sb-Te material have been characterized. In the amorphous state, the optical band gap, from optical absorption measurements, has been shown to be insensitive to concentrations of Sb from 0 to 35 atomic % and has been measured at about 0.7 eV. The electrical activation energy of the material decreases slightly from about 0.4 eV in the amorphous GeTe system to about 0.35 eV in the Ge₂₂Sb₂₂Te₅₆ system.

Upon annealing, amorphous films, regardless of composition, crystallize into the face centered cubic phase. The electrical conductivity of these films increases from about 10⁻³ (ohm-cm)⁻¹ in the amorphous phase to about 1 (ohm-cm)⁻¹ in the face centered cubic crystalline phase. This transition occurs at approximately 180°C. The Fermi level position for this face centered cubic lattice is about 0.18 eV which is approximately half the measured optical band gap of about 0.4 eV. Further annealing in the range of about 180 to about 300°C does not change either the electrical conductivity or the optical transmission of the material. The infrared absorption, measured in the range of 1 to 50 micrometres (microns) is negligible, which indicates a relatively low concentration of free charge carriers in the face centered cubic structure. Thermal annealing at 350°C results in a further phase transition to the hexagonal crystalline lattice structure. In this state of the lattice, the electrical conductivity further increases to about 100 (ohm-cm)⁻¹ and a strong free carrier absorption appears following the known relation α = A λ², where α is the absorption coefficient, λ is the wavelength of incident light and A is a constant proportional to the number of free carriers. In accordance with our measurements, the optical band gap of the material does not significantly change after the phase transformation between the face centered cubic and the hexagonal states has occurred. However, a strong (≈25%) increase in reflectivity has been measured.

In order to cycle the novel memory element of this invention, a process is required in which a relatively high level of energy is applied to the material prior to its initial use to convert the material into a first crystalline state. The Fermi level position for this crystalline state is on the order of about 0.18 eV, which is the same as the Fermi level position reported above for the face centered cubic structure, providing for the conclusion that the material has undergone a phase transformation from the amorphous into a face centered cubic crystalline lattice structure. Also, upon the application of additional, lesser amounts of energy, the Fermi level position was lowered. which indicates that the material has undergone a further crystalline phase transformation into the hexagonal crystalline lattice phase described above. Thus, it has been established that the stable modulation of the crystallites of the microcrystalline semiconductor material of the present invention, into and through a range of different Fermi level positions, is accomplished by changing and cycling the crystalline lattice structure of the grains of this material.

The reversible change in electrical conductivity exhibited by this microcrystalline semiconductor material is provided at least within one crystalline phase of the material. This change in the value of electrical conductivity of about two orders of magnitude closely corresponds to the difference in the dynamic range of the resistance of the electrical memory elements of the present invention, as measured in the laboratory for the bulk material.

In order to convert the material from a crystalline state such as the face centered cubic state to a state of differing resistance, it is necessary to employ a shorter, more energetic electrical pulse. For example, a 30 nanosecond pulse is able to transform the hexagonal lattice structure in a thin film of microcrystalline chalcogenide material into the face centered cubic lattice structure. By measuring the free charge density before and after annealing, it was found that no significant free carrier absorption takes place. This suggests that crystalline films in the face centered cubic structure have a lower concentration of thermally excited free charge (holes) as opposed to the films in the hexagonal phase, which may be thought of as a p-type, highly degenerate semiconductor material (because the Fermi level has been moved adjacent to, or all the way into, the valence band).

It is noted that the end points of the dynamic range of electrical conductivities (determined by the Fermi level positions) set forth in the present invention do not necessarily correspond to a change of crystalline states between the face centered cubic and the hexagonal lattice structures. Rather, what is more significant is the fact that the material need never revert back to the amorphous structure and, thus, the end points in the dynamic range of electrical conductivities may both result from one or more crystalline lattice structures and can therefore be attained with relatively low energy inputs and at very high speeds.

If one considers that the concentration of free charge and the structure of the crystalline lattice are to some extent uncoupled, there is a possible mechanism that could be employed to provide information helpful in understanding the presence of the multiple stable intermediate states. It is known that the presence of an external electrical field will cause charge to drift and thereby strain the lattice. The two responses are independent. In order to change the number of vacancies in the tellurium-antimony matrix, germanium and or antimony atoms have to be moved. It is possible that the response of the strained lattice during the application of an external field is to either break some bonds and create additional acceptor levels (higher concentration of holes within the lattice) or to simply move non-bonding lone pair electrons in their local environment and\or have said lone pair interact with each other to create or dissolve states in the energy gap. In any event, the end result is independent of the previous amorphous or crystalline state of the material.

Through experimentation, the inventor has shown that factors such as pore dimensions (diameter, thickness, and volume), chalcogenide composition, thermal preparation (post deposition anneal), signal pulse duration, impurities such as oxygen present in the composition. crystallite size and signal pulse waveform shape have an effect on the magnitude of the dynamic range of resistances, the absolute end-point resistances of said dynamic range, and the voltages required to set the device at these resistances. For example, relatively thick chalcogenide films (i.e. about 40nm (4000 **Å**)) will result in higher set voltage requirements (and therefore higher current densities within the volume of memory material), while relatively thin chalcogenide layers (i.e. about 25nm (250 **Å**)) will result in lower set voltage (and current density) requirements. Of course, the possible significance of crystallite size and, therefore, the ratio of the number of surface atoms relative to the number of bulk atoms has previously been described.

The inventor speculates that the materials actually operate at the extreme ends of the hexagonal lattice structure so it is not surprising that a very low energy input can cause significant changes in Fermi level position and resistance values. Further, the inventor speculates that a change to the hexagonal/rhombohedral phase from the face centered cubic phase can be explained by movement by as few as 2% of the germanium and/or antimony atoms from the crystallite in their attempt to assume a preferred compositional ratio (Te₅₂Ge₄₈ is preferred in the binary composition). Since the loss of each atom provides the crystallite with an extra hole, there would be an increase in free charge concentration per cubic centimeter on the order of 10²¹, a value which would not be masked by thermal generation in this narrow band gap material. It is this type of increase in free charge concentration which will be referred to herein as "self-doping" or "self-compensation". It is additionally noteworthy that the band gap of these semiconductor compositions can be widened or further narrowed by alloying with other semiconductor materials such as silicon or sulphur or carbon. Further, reductions in set current could also be achieved by alloying the composition with other semiconductor materials such as selenium.

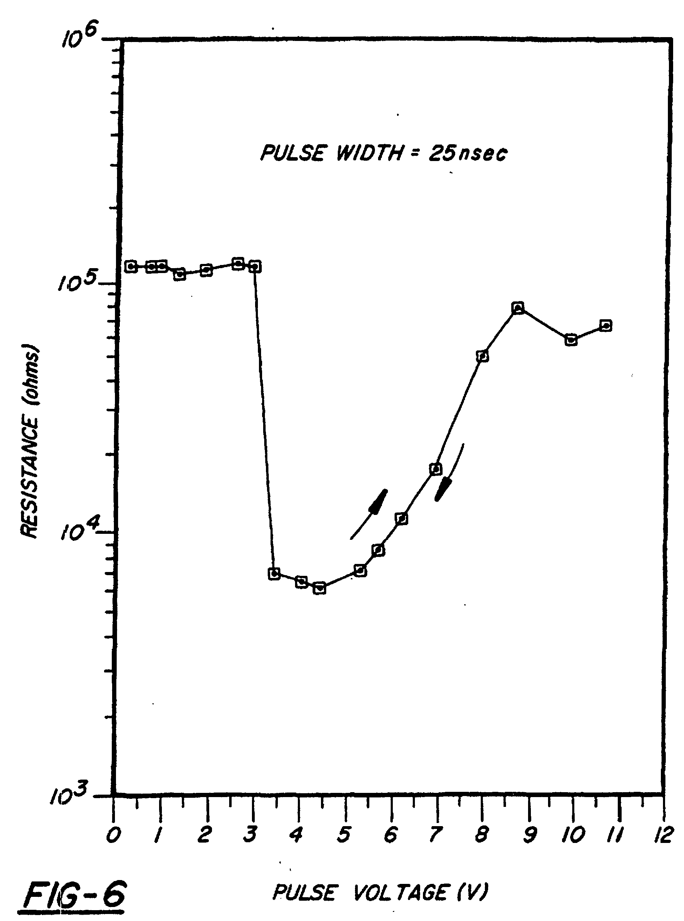

Retuming to the drawings, Fig. 6 is a graphical representation in which the resistance of memory elements formed of the novel semiconductor material of the instant invention is plotted on the ordinate and the applied pulse voltages for pulse durations of 25 nanoseconds are plotted on the abscissa. This figure clearly demonstrates, inter alia, the wide dynamic range of resistance values attainable with the particular semiconductor material and device structure and size. The dynamic range of electrical resistances illustrate for this specific device is greater than about one order of magnitude. The data in Fig. 6 shows a constant resistance value for input pulses of less than about 3 volts. When a 3 volt pulse is applied, the device resistance instantaneously drops to about 6 x 10³ ohms, which value corresponds to the low resistance end of the dynamic range. Upon the application of higher electrical voltage pulses, from 4 volts to 9 volts, the device resistance increase linearly to about 7 x 10⁴ ohms, which corresponds to the high resistance end of the dynamic range. The linearity of this resistance versus voltage plot, as well as the remarkable ability to proceed in both directions along this plot, without being reset into the "starting state" is to be noted. It is this wide dynamic range, the linearity of the plot, and the ability to move in both directions along the plot that provides that this semiconductor material may be used for memory applications characterized by directly overwritable, multilevel storage capabilities.

The signal pulse duration required to set the memory element to the desired resistance level within the dynamic range of electrical resistances will likewise be dependent upon all of the foregoing factors as well as signal voltage. Typically signal pulse durations will be less than about 250 nanoseconds and preferably less than about 50 nanoseconds. It is to be stressed that even the short 25 nanosecond pulse widths noted are dependent on the size and shape of the pore as well as the thickness and composition of the semiconductor alloy employed. It is believed that the pulse durations can be significantly reduced without interfering with the operation of the memory switch. As a matter of fact, with the input of lesser amounts of energy, the cycle life of the elements can only increase.

A feedback loop which reads and, when required, adjusts the resistance of a given memory element may be incorporated into the memory systems of the instant invention. For example, a memory element may initially be set at a desired resistance; however, in time the resistance of the element may drift slightly from the value at which it was originally set. The feedback loop, in this instance, would calculate and deliver a refresh signal pulse of the required voltage and duration to the memory element to bring it back to a preselected resistance value. Also, circumstances may exist where the set pulse delivered to a memory element may not result in setting of the element at the desired resistance value. In this case the feedback loop would deliver additional signal pulses to the element until the desired resistance level is achieved. The total duration of this series of set/adjust cycles is less than about 1,000 nanoseconds and preferably less than about 500 nanoseconds.

The ability to reversibly move up and down the linear portion of the resistance versus voltage curve cannot be overemphasized. As indicated by the arrows in Fig.6, a signal pulse of a selected voltage will set the memory element to a desired resistance, regardless of the previous set condition thereof. This ability to reversibly move along the curve provides for direct overwrite of previously stored data. Such direct overwrite capability is not possible with the phase change and MSM (a-Si) memory materials of the prior art. This ability to reversibly set intermediate resistance values is remarkable. A thousand successive 5-volt pulses achieves the same resistance value as an 8-volt pulse followed by a single 5-volt pulse or a 4-volt pulse followed by a single 5-volt pulse. It is therefor no wonder that an explanation of the physics of the remarkable operation of this revolutionary material is so difficult.

The dynamic range of resistances also allows for broad gray scale and multilevel analog memory storage. This multilevel memory storage is accomplished by dividing the broad dynamic range into a plurality of sub-ranges or levels. This analog storage ability allows for multiple bits of binary information to be stored in a single memory cell. This multilevel storage is accomplished by mimicking multiple bits of binary information in analog form and storing this analog information in a single memory cell. Thus, by dividing the dynamic range of resistances into 3 or more analog levels, each memory cell would be provided with the capability of storing 1 and 1/2 or more bits of binary information.

Fig. 7 is a tabular representation of electrical and optical data generated from typical Te-Ge-Sb compositions belonging to the novel class of semiconductor materials of the present invention. This data was generated from samples deposited by sputtering and then being subjected to a post deposition thermal anneal in air. As can be seen from this data, the as prepared amorphous phase has a band gap of about 0.7 eV, a Fermi level position of about 0.37 eV, and an optical reflectivity of about 35%. This material, when in the amorphous phase, behaves as an intrinsic narrow band gap semiconductor. However, it is the electrical and optical characteristics of the two crystalline lattice phases into which the amorphous material can be modulated that are of particular interest. The "as prepared" face centered cubic phase of that same composition has a band gap of about 0.4 eV, a Fermi level position of about 0.18 eV, an optical reflectivity of 48%, and behaves as an intrinsic narrow band gap semiconductor material. Further, the hexagonal phase of that sample has a band gap similar to the face centered cubic phase, but has a wide dynamic range of Fermi level positions ranging from about 0.0 to about 0.18 eV depending on the state of thermal anneal. The hexagonal phase has an optical reflectivity range of about 48 to about 73% and behaves as a narrow band gap, p-type, degenerate semiconductor material. This range of Fermi level positions and the resultant wide dynamic ranges of electrical (conductivity/resistance) and optical (reflectivity) properties allows for gray scale electrical and optical storage of information. The degenerate behavior, i.e., the movement of the Fermi level position into the valence band edge, is remarkable. The concentration of free charge must be very high in order to measure this behavior in a narrow band gap material wherein thermal charge generation normally swamps such extrinsic behavior. Therefore, this high concentration of holes is one of the most significant aspects of the invention.

The switching modulations of the instant electrical memories require much less energy than those of the prior art. Based upon our present understanding, this is not surprising. All prior art materials relied upon amorphous-to-crystalline phase transitions; whereas the instant materials operate on either crystalline-to-crystalline phase transitions or operate within a single crystalline phase and the increase in electrical conductivity resulting from these phase transitions.

The inventors speculate that the materials actually operate at the extreme ends of the hexagonal lattice structure so it is not surprising that a very low energy input can cause significant changes in Fermi level position and resistance values. Further, the inventors speculate that a change to the hexagonal/rhombohedral phase from the face centered cubic phase could be explained by movement by as few as 2% of the germanium and/or antimony atoms from the crystallite in attempt to assume a preferred compositional ratio (Te₅₂Ge₄₈ is preferred in the binary composition). Since the loss of each atom provides the crystallite with an extra hole, there would be an increase in free charge concentration per cubic centimeter on the order of 10²¹, a value which would not be masked by thermal generation in this narrow band gap material. It is this type of increase in free charge concentration which will be referred to herein as "self-doping" or "self-compensation. It is additionally noteworthy that the band gap of these semiconductor compositions can be widened or further narrowed by alloying.

It has been observed that the oxygen content of the thin film memory material either controls, or plays a significant role in controlling, the crystallite size thereof. As mentioned above, the crystallite size generally, and the relative ratio of the number of atoms within the bulk of the crystallite relative to the number of atoms surrounding that crystallite is believed, in turn to control the Fermi level position (and therefore the extrinsic electrical conductivity) of the semiconductor material. Additionally, oxygen may represent an impurity atom which provides the chalcogenide composition with an increased number of defect states for intrinsically altering the electrical conductivity of thereof. This electrical behavior has been shown to be significantly different than the behavior of all other previously known chalcogenide memory materials.

As indicated hereinabove, Fig. 8 is a ternary diagram of the Ge-Te-Sb semiconductor alloy system. In addition to the information previously discussed of which the binary and ternary phases are indicated by squares (■), this diagram gives information on the segregation of other alloys. These other alloys are indicated by triangles (▲), diamonds (◆) and circles (●) and the phases into which the alloys segregate, upon rapid solidification from the melt, are indicated by the lines (solid or dashed) which extend therefrom. The starting compositions of two Te-rich melts are indicated by circular symbols on the ternary diagram. Upon rapid solidification, these mixtures phase segregate into elemental Te plus phases B, C and D.

Melts with compositions to the right of the pseudobinary line, indicated by diamond symbols, solidify into the phases indicated by the lines on the diagram. Other mixtures. indicated by triangles in the phase diagram, solidify into elemental Ge and Sb and into phase A. Phase A is found in the rapid solidification of all melts where the composition of the melt is close to that of phase A, an also in the compositions indicated by the triangle symbols on the diagram. A molten mixture of compositions identical to that of phase A forms nearly pure phase A upon rapid solidification. This phase is the only phase which shows this characteristic. An alloy of particular interest for use in the improved memory elements of the present invention is Ge₂₂Sb₂₂Te₅₆, also referred to as Ge₂Sb₂Te₅ or 2-2-5. This 2-2-5 alloy, upon rapid solidification, phase segregates into a mixture of two distinct phases of compositions B (Ge₂₆Sb₁₈Te₅₆) and C (Ge₁₈Sb₂₆Te₅₆) indicated in the phase diagram of Fig. 8. Another alloy of particular interest is Ge₁₄Sb₂₉Te₅₇ ( also referred to as GeSb₂Te₄ or 1-2-4) which is composition D on the GeTe-Sb₂Te₃ pseudobinary line. The 2-2-5 and 1-2-4 alloys are of interest for forming the volume of memory material in compositionally graded, layered or combine graded\layered form, as discussed hereinabove.

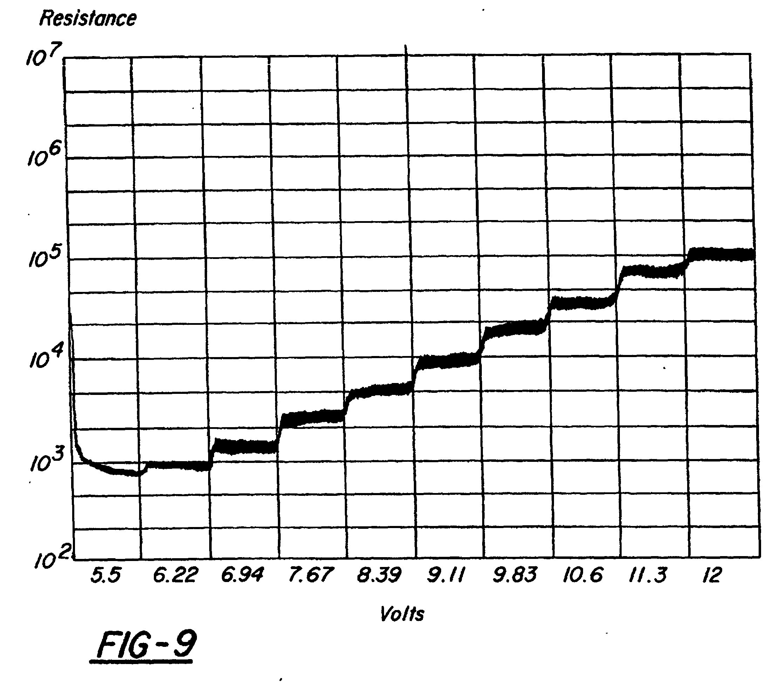

Fig. 9 is a graphical representation of data taken on the improved memory elements of the instant invention particularly depicting the stable set resistance. The resistance of the memory element is plotted on the ordinate and the set pulse voltage is plotted on the abscissa. To obtain this data, a memory element was set to a selected resistance by an input pulse of voltage, as indicated on the abscissa. The input pulse duration was 30 nanoseconds with 3 nanosecond rise and fall times. After being set to the selected resistance, the actual resistance value of the element was read 1000 times. One tenth of read values were plotted on the graph. The memory element used to generate the experimental data of Fig. 9 was compositionally graded. In this embodiment, the volume of memory material was continuously and uniformly graded between the aforediscussed 1-2-4 and 2-2-5 Ge-Sb-Te alloys.

From a perusal of Fig. 9, it can be clearly seen that the memory elements of the present invention have set resistance values which exhibit little, if any, resistance value drift (outside a selected margin of error) within the time period studied. This ability to be set to a selected resistance value without substantial drift thereof represents an essential characteristic in that substantial drift of the memory element's resistance value (i.e. outside the allowed error margins) will result in loss of stored information. The term "rise time", as used herein, refers to the time interval between signal initiation and the moment in which peak signal power is reached, during which signal power continuously increases. Analogously, the term "fall time", as used herein, refers to the time interval between the moment of cessation of peak signal power and final signal discontinuation, during which signal power continuously decreases.

Fig. 10 depicts the atomic structure of three ternary alloys of the Ge-Sb-Te system as well as the atomic structure of the binary alloy Ge-Te. Two of the three ternary alloys are the 1-2-4 (composition D on the ternary diagram of Fig. 8) and the 2-2-5 compositions described hereinabove. The third ternary alloy is Ge₈Sb₃₃Te₅₉ which is also referred to as GeSb₄Te₇ or 1-4-7. This 1-4-7 alloy corresponds to composition E on the ternary phase diagram of Fig. 8. In the depictions of the atomic structures of these alloys, the hollow circles represent Ge atoms, the striated circles represent Sb atoms and the stippled circles depict Te atoms. As shown by Fig. 10, the atomic configuration of each of the alloys, when in the face centered cubic crystalline structure, is formed of ordered, repeated layers of atoms. The fcc configuration form three distinct types of layers which are labeled A, B and C in Fig. 10. Layers of type B and C are three atom layers, while layers of type A are 7 atom layers.

The 1-4-7, 1-2-4, and 2-2-5 alloys depicted in Fig. 10 are of interest as base memory materials and for use in the elementally modified memory materials of the instant invention. The transition metals, along with Se, when present, are incorporated relatively uniformly throughout the Te-Ge-Sb matrix and enhance the electronic/atomic structure so as to produce reduced switching current requirements and increased thermal stability of data retention. Current analysis shows that the Se replaces Te in the structure, and while the exact positioning of the transition metal is not known, it appears that the transition metal bonds with the chalcogen element.

Also, as mentioned hereinabove, when the Ge-Sb-Te alloy materials are deposited by evaporation onto a heated substrate, the materials are deposited in anisotropic form. That is, when deposited in this fashion, the crystallites of the alloy materials are oriented such that the layers of constituent atomic elements are aligned substantially parallel to the substrate surface. This will, of course, result in anisotropic current flow, but offers the long term possibility of arranging the atoms of the material so as to employ set and reset pulses in the low resistance direction and thereby achieve still lower set and reset currents, voltages and/or energies.

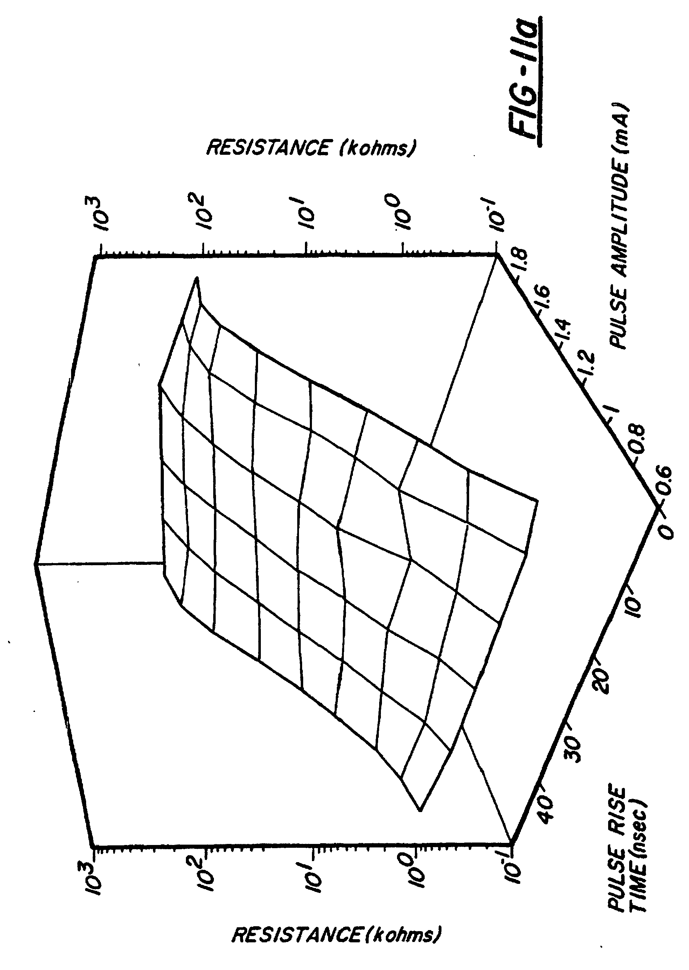

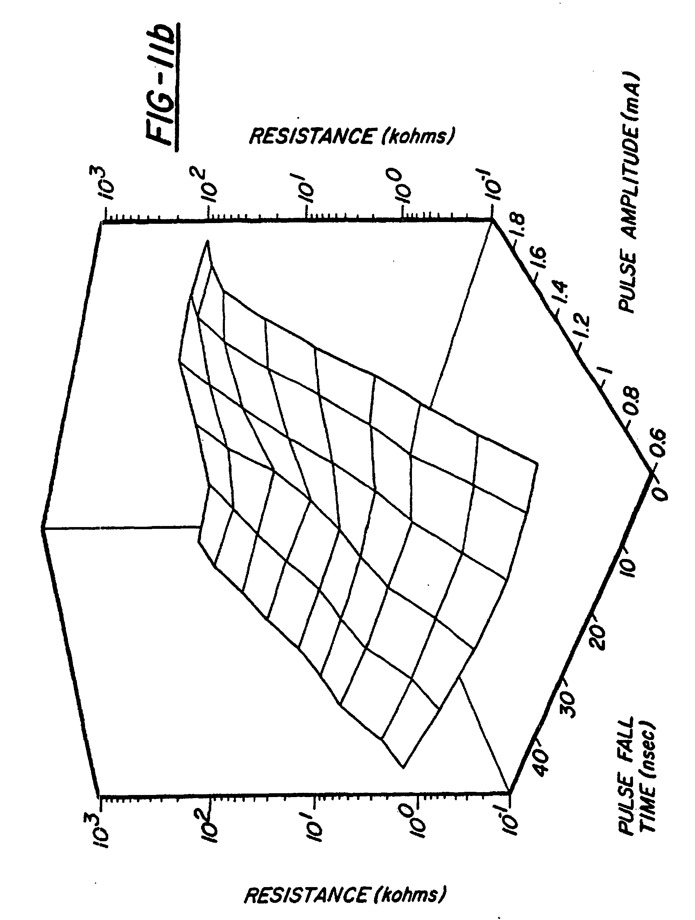

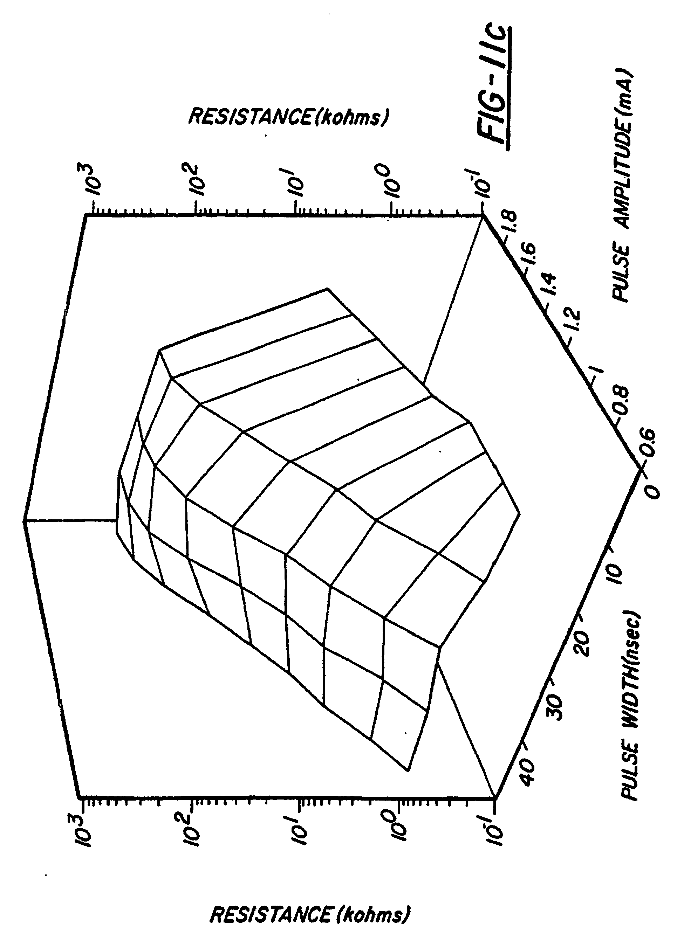

Figs. 11a, 11b and 11c are three dimensional graphs depicting device resistance (in kohms) versus input set pulse amplitude (in mA) and one of pulse rise time, pulse fall time or pulse width (in nsec), respectively. Fig. 11a depicts device resistance as a function of pulse rise time (defined hereinabove) for various pulse amplitudes, with pulse fall times of 3 nanoseconds and pulse widths of 27 nanoseconds plus pulse rise time. Fig. 11b depicts device resistance as a function of pulse fall time (defined hereinabove) for various pulse amplitudes, with pulse rise times of 3 nanoseconds and pulse widths of 30 nanoseconds. Fig. 11c depicts device resistance as a function of pulse width for various pulse amplitudes, with pulse rise and fall times of 3 nanoseconds each.

As can be seen from these figures, and as was mentioned hereinabove. the electronic characteristics of the memory elements (i.e. such as magnitude of the dynamic range of resistance, absolute endpoint resistances, slope of the resistance versus pulse amplitude curve, etc.) can be adapted to meet specific current/voltage requirements by adjusting the pulse width, rise time and fall time. It is to be noted that, within the range of tested pulse widths, all widths greater than about 30 nanoseconds give essentially identical results. This fact, in combination with the weak dependence on pulse rise and fall times, allows for wide margins in programming pulse parameters.

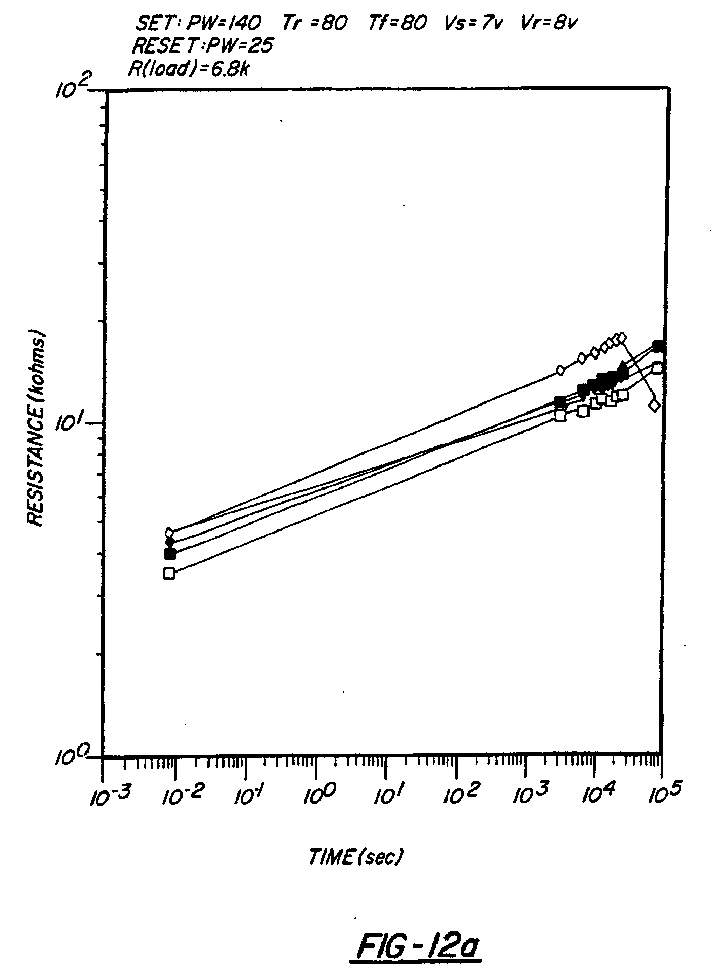

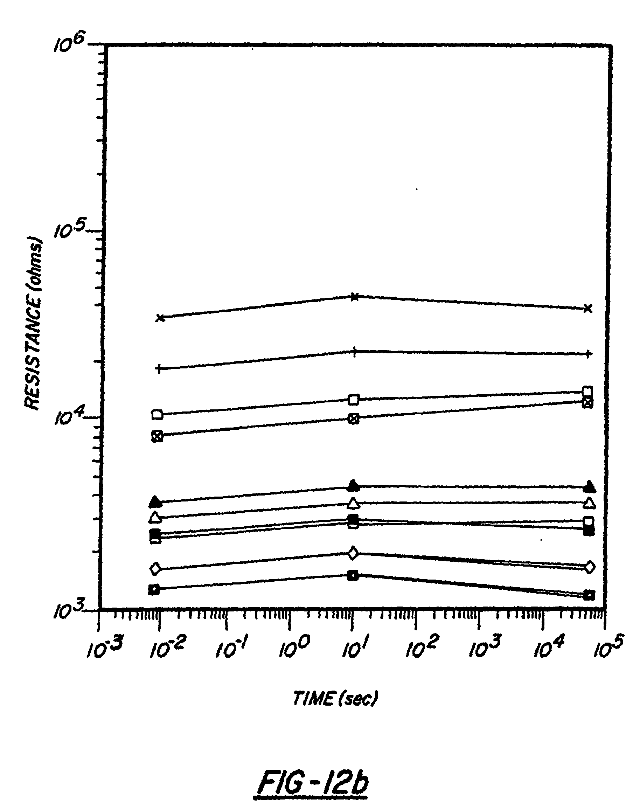

Figs. 12a and 12b are graphical representations of data taken of memory elements without and with the use of compositional modification for stabilizing the set resistance value, respectively. In these graphs, device resistance is plotted on the ordinate and time since setting the memory element is plotted on the abscissa. Fig. 12a depicts data taken for five different memory elements fabricated of a volume of memory material formed of a single Ge-Sb-Te alloy. These memory elements were set to a selected resistance and, at various times thereafter, the resistance value of the elements was measured. This data clearly shows that these memory elements (i.e. those which do not employ compositional modification) exhibit higher values of resistance drift. Fig. 12b depicts data taken for twelve different memory elements fabricated of a volume of memory material which is continuously and uniformly compositionally graded from a first Ge-Sb-Te alloy (1-2-4) to a second Ge-Sb-Te alloy (2-2-5). More particularly, a first discrete layer of 1-2-4 alloy was deposited. Atop this 1-2-4 layer, the composition was uniformly and continuously modified over the 100nm (1000 Angstrom) total thickness of the chalcogenide material so as to assume a 2-2-5 composition at the opposite surface of the thickness. Note that this is readily accomplished through the use of co-evaporation or cosputtering targets. These memory elements were set to selected resistances within the dynamic range of resistance values by input pulses of between 5 and 11 Volts. Again, at various times thereafter, the resistance value of the memory elements was measured. The data plotted in Fig. 12b clearly indicate that the memory elements which include a volume of memory material which employ compositional modification exhibit substantially stable resistance values over time as compared to memory elements without compositional modification. The inventor is unable to explain the mechanism by which compositional modification operates to stabilize the set resistance values. The mechanism may be as simple as providing a template for nucleating the growth of the subsequently deposited material or providing a "growth explosion profile" or the mechanism may be as complex as placing strain on the lattice structures of the memory material. Regardless of mechanism, the instant invention is meant to encompass those forms of compositional modification which stabilize the set resistance of the memory material.

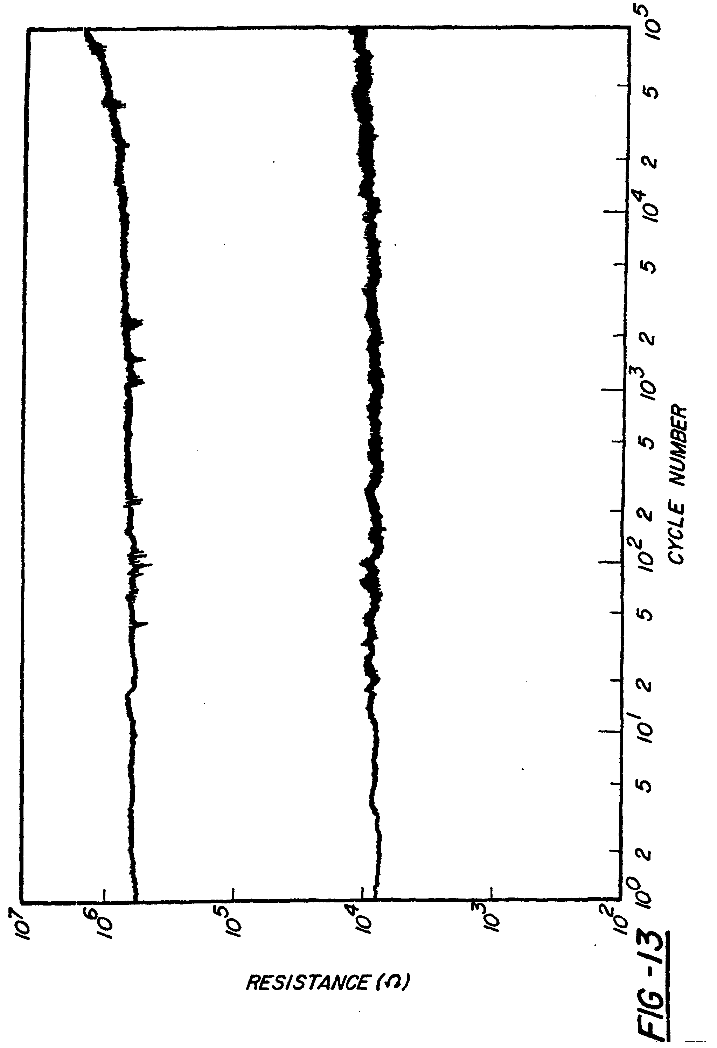

Fig. 13 is a graphical representation of data taken for a memory element having a nominal chemical composition of (Te₅₆Ge₂₂Sb₂₂)₉₀Ni₅Se₅ without a thin-film silicon layer in the contact layer. Fig. 13 depicts device resistance plotted on the ordinate versus write/erase cycle number plotted on the abscissa. The element was switched using pulses of 40 nanoseconds duration at 3.1 Volts and 2 milliamperes current to set the element at the high resistance value and pulses of 400 nanoseconds duration at 1.9 Volts and 1 milliampere current to set the element to the low resistance value. This graph shows fairly stable switching between two detectable values of resistance using switching pulses of relatively low current but a life of only about 10⁵ write/erase cycles.

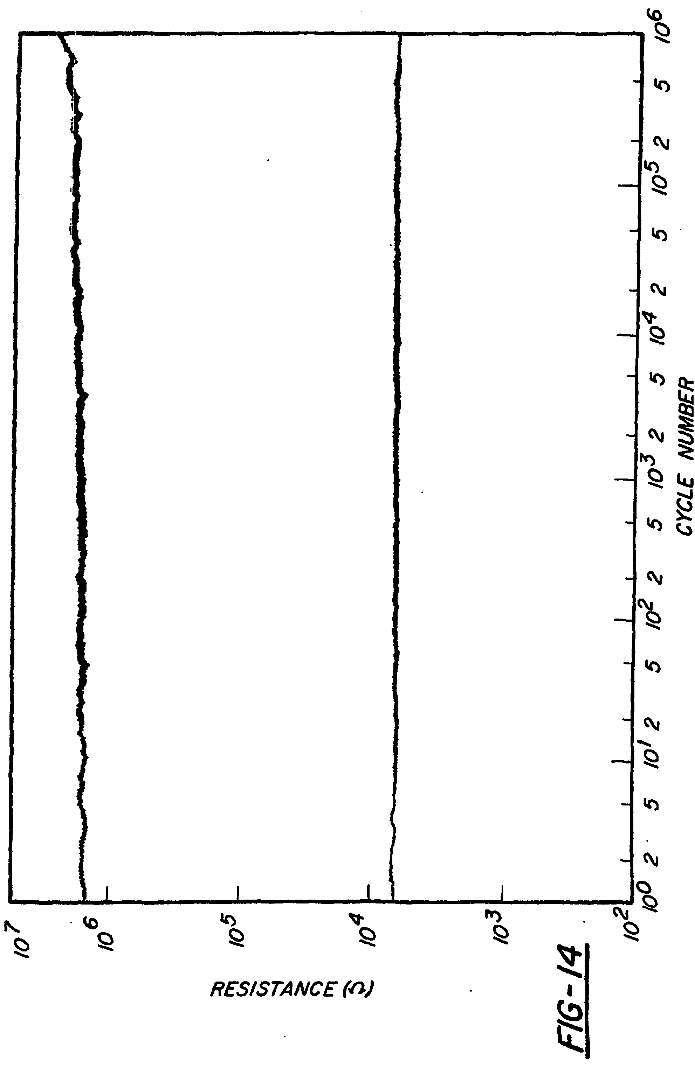

Fig. 14 is a graphical representation of data taken for a memory element including a volume of memory material having a nominal chemical composition of(Te₅₆Ge₂₂Sb₂₂)₉₀Ni₅Se₅ with a 20nm (200 **Å**) thin-film amorphous silicon contact layer disposed between the volume of memory material and the amorphous carbon layer. Fig. 14 depicts device resistance plotted on the ordinate versus write/erase cycle number plotted on the abscissa. The element was switched using pulses of 25 nanoseconds duration at 4.2 Volts and 1.5 milliamperes current to set the element at the high resistance value and pulses of 400 nanoseconds duration at 2.0 Volts and 0.5 milliampere current to set the element to the low resistance value. This graph shows stable switching between two detectable values of resistance using switching pulses of remarkably low current and a life of at least about 10⁶ write/erase cycles.

A comparison of devices with and without the structural modification, demonstrates that the devices having the silicon contact layer are improved in a number of physical/electrical properties. The switching stability has been increased; that is, the noise level of the data (i.e. the difference between the expected resistance and the actual resistance for a given input pulse) has been noticeably decreased. Along with the increased switching stability, the absolute magnitude between the high and low resistance values has also increased. Additionally, current requirements have been reduced by between 25 and 50 percent by the addition of the layer of silicon contact. Finally, the cycle life of the structurally modified elements has been increased by at least an order of magnitude.

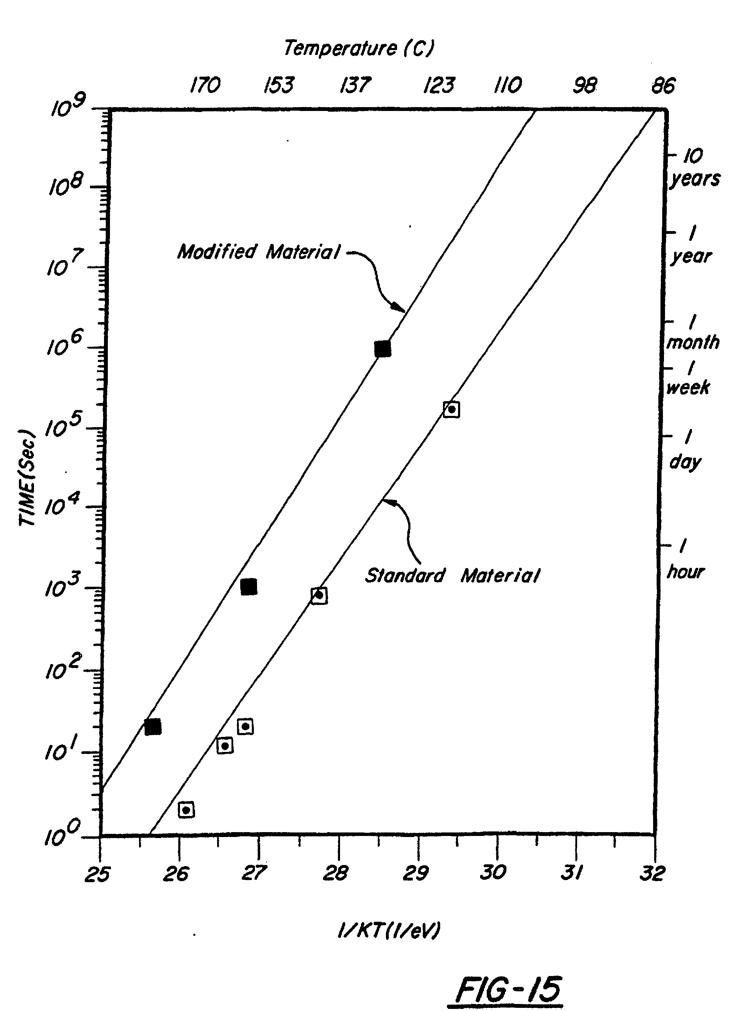

Fig. 15 is a graphical representation of data taken for a memory element including a volume of memory material having a nominal chemical composition of (Te₅₆Ge₂₂Sb₂₂)₉₀Ni₅Se₅ (i.e. the modified material) and a memory element including a volume of memory material having a nominal chemical composition of Te₅₆Ge₂₂Sb₂₂ (i.e. the standard material), specifically depicting data retention time plotted on the ordinates versus device temperature (or a function thereof) on the abscissas. The data retention test consists of heating the device to a desired test temperature and then applying an electrical pulse thereto to switch the device to a high resistance stare. Immediately thereafter the resistance of the device is read numerous times to evaluate the effect of the increased temperature thereon. Typically, the resistance is rises for a short time and then begins to fall. The criterion used herein for loss of data is the point in time at which the device resistance falls to a value below that which was measured immediately after the electrical pulse was applied.

A perusal of Fig. 15 shows that devices incorporating the standard memory material will retain their data for about 10 years at a continual temperature of about 90 °C. while the memory devices of the instant invention which incorporate the modified memory material will retain their data for about 10 years at a temperature of about 110 °C. This is a increase over the standard memory material and makes the memory elements incorporating the modified memory material much more reliable in high temperature uses.

Through the use of the proprietary materials and device configurations disclosed herein, an electrically erasable, directly overwritable memory element has been developed which provides fast read and write speeds, approaching those of SRAM devices: non-volatility and random access reprogramming capabilities of an EEPROM: and a price per megabyte of storage that approaches that of hard disk memory.

It is possible that the ramifications of the free charge concentration modulation capabilities of the materials of the present invention will have economic impact in the field of semiconductor devices. As detailed in the background section above, the charge carrier modulation disclosed herein represents a fifth type of charge carrier modulation, one that represents a fundamental departure from the prior art. Simply stated, in the materials of the present invention, even after removal of the field, the Fermi level position, the elecaical conductivity, and the concentration of free charge remain fixed. Thus, it becomes possible to build either a new class of semiconductor devices in which three terminals or two terminals can be employed and the device is preprogrammed to preselected values of electrical resistivity. In either event, the programming voltages and/or currents are remarkably low and the reaction speeds are remarkably fast. This is because the semiconductor materials of the present invention have inherent speed and energy capabilities resulting from modulation that occurs within one or more different crystalline phases.

Note that, as should be apparent from a perusal of the subject specification, we are able to see a trend in performance of the memory elements that is generally related to pore diameter. When we use devices in the binary mode, we see a general increase in the off-to-on resistance ratio as we test devices across a wafer in which pore diameters range systematically from just over one µm (micron) to not open at all. If the pore diameter is controlled within the range of, for example, from one µm (micron) to less than one half of a µm (micron), there is an opportunity to improve the performance of our devices. Since volumetric factors such as current density and energy density are important in the programming of our devices, reduction in device volume, resulting from reduction in pore diameter, should result in an increase in sensitivity and speed.

There is a threshold switching event associated with the programming of the Ovonic EEPROM and, therefore, one expects that, like other threshold switches, the Ovonic EEPROM programming voltage will show a chalcogenide alloy film thickness dependence. In fact, in the Ovonic EEPROM, a threshold switching voltage serves to separate read events from programming events, eliminating read upset and providing good operational margin during data reading. Our devices show linear resistance characteristics when the applied field is low, followed by a gradual decrease in resistance with increasing field, up to a threshold voltage. Once the threshold voltage is exceeded, the device exhibits a negative resistance transition to a highly conductive, "dynamic on" state. When the applied field is removed, the device returns to a non-volatile programmed resistance state, the value of which depends on the current/energy profile the device has experienced during its "memory equilibration time" while in the dynamic on state. Although the threshold voltage depends on the resistance of the device, the device current at the threshold voltage is relatively constant for all device resistances. A linear approximation to the thickness, threshold voltage relationship shows a proportionality factor of less than one, which contributes to a wide operating margin in devices having the same nominal thickness.

As the device thickness is reduced, the absolute resistance of the device will decrease proportionally. At same thicknesses, however, contact resistances can be expected to dominate over the smaller resistance values of the memory material. With the amorphous carbon electrodes we are currently using for our test devices, this contact resistance effect will be less significant than the lower conductivity silicide electrode materials, such as palladium silicide or tungsten silicide, which are more conventionally used in wafer fabrication facilities. As mentioned hereinabove, carbon was originally selected because of its ability to prevent interdiffusion; however with the use of a contact such as tungsten silicide, diffusion of tungsten into the chalcogenide would provide additional p-orbitals and thereby enhance the electronic switching set forth herein.

It is to be understood that the disclosure set forth herein is presented in the form of detailed embodiments described for the purpose of making a full and complete disclosure of the present invention, and that such details are not to be interpreted as limiting the true scope of this invention as set forth and defined in the appended claims.

## Claims

1. An electrically operated memory element (30) comprising:
(a) a volume of memory material (36) formed of a semiconductor material including at least one chalcogen element and capable of being switched between at least two electrically detectable states in response to selected electrical input signals, and
(b) a pair of spacedly disposed contacts (32, 34, 38, 40) for supplying said electrical input signals to said volume of memory material (36),
**characterized in that** in each of said electrically detectable states at least a portion of said volume of memory material (36) being in the crystalline state,
said volume of memory material (36), in response to said selected electrical input signals, having
- multibit storage capabilities throughout a dynamic range of electrical resistance values, and
- being directly overwritable with the ability to be set directly to one of a plurality of resistance values within said dynamic range without the need to be set to a specific starting or erased resistance value, regardless of the previous resistance value of said memory material (36).

2. The memory element of claim 1,
**characterized in that,**
said volume of memory material (36) being disposed between said contacts (32, 34, 38, 40), wherein said contacts (32, 34, 38, 40) provide terminals for reading information stored in and writing information to said memory element (30).

3. The memory element of one of the preceding claims,
**characterized in that,**
said volume of memory material (36) is setable to each of said resistance values, wherein said memory material (36) remains set at said value after said input signal has been terminated.

4. The memory element of one of the preceding claims,
**characterized in that,**
said volume of memory material (36) has a thickness between 50 nanometers (500 Å) and 500 nanometers (5000 Å).

5. The memory element of one of the preceding claims,
**characterized in that,**
said volume of memory material (36) is setable to one of at least 4 distinct detectable resistance values within said dynamic range in response to said selected electrical input signals.

6. The memory element of one of the preceding claims,
**characterized in that,**
said volume of memory material (36) includes one or more elements selected from the group consisting of Se, Te and mixtures or alloys thereof.

7. The memory element of one of the preceding claims,
**characterized in that,**
said volume of memory material (36) includes one or more elements selected from the group consisting of Ge, Sb, Bi, Pb, Sn, As, S, Si, P, O and mixtures or alloys thereof.

8. The memory element of claim 7,
**characterized in that**
each of said elements is present throughout the entire volume of said volume of memory material (36).

9. The memory element of one of the preceding claims,
**characterized in that,**
said volume of memory material (36) includes at least one transition metal element, preferably at least one element selected from the group consisting of Cr, Fe, Ni, and mixtures or alloys thereof.

10. The memory element of one of the preceding claims,
**characterized in that,**
said volume of memory material (36) includes Te, Ge and Sb in the ratio TeₐGe_{b}Sb_{100-(a+b)} where the subscripts are in atomic percentages which total 100% of the constituent elements and 40 ≤ a ≤ 58 and 8 ≤ b ≤ 40.

11. The memory element of one of the preceding claims,
**characterized in that,**
each contact (32, 34, 38, 40) of said pair of spacedly disposed contacts (32, 34, 38, 40) includes a thin-film layer of silicon material disposed in direct contact with said volume of memory material (36).

12. The memory element of claim 11,
**characterized in that,**
each of said two spacedly disposed contacts (32, 34, 38, 40) includes a thin-film layer of carbon material disposed on one side of said thin-film layer of silicon material remote from said volume of memory material (36).

13. The memory element of claim 12,
**characterized in that**,
each of said two spacedly disposed contacts (32, 34, 38, 40) includes a thin-film layer of molybdenum material disposed on said thin-film layer of carbon material.

14. The memory element of claim 11,
**characterized in that,**
said thin-film layer of silicon material of said spacedly disposed contacts (32, 34, 38, 40) is originally in an amorphous state, wherein a portion of said thin-film layers is capable to crystallize during an initial forming/switching.

15. The memory element of claim 12 or 13,
**characterized in that,**
said thin-film layers of silicon and carbon material of said spacedly disposed contacts (32, 34, 38, 40) are originally in an amorphous state, wherein a portion of said thin-film layers are capable to crystallize during an initial forming/switching.

16. The memory element of one of the preceding claims,
**characterized in that,**
said volume of memory material (36) includes means for varying the positional composition of said volume of memory material (36) so as to substantially stabilize the resistance of said memory material (36) at a selected resistance value and said volume of memory material (36) adapted to remain set at said selected resistance value without drift after the input signal has been terminated.

17. The memory element of claim 16,
**characterized in that,**
said means for varying the positional composition of said volume of memory material (36) includes the addition of a band gap widening element to said volume of memory material (36).

18. The memory element of claim 16,
**characterized in that,**
said means for varying the positional composition of said volume of memory material (36) includes an increase in covalent bonding'.

19. The memory element of claim 16,
**characterized in that,**
said volume of memory material (36) includes at least one constituent atomic element which contains lone pair electrons, and said means for varying the positional composition of said volume of memory material (36) includes a modification of the local environment of said lone pair electrons to create or remove defect states in the band gap of the semiconductor material.

20. The memory element of claim 16,
**characterized in that,**
said means for varying the composition includes compositional grading and/or compositional layering of said volume of memory material (36).

21. The memory element of claim 20,
**characterized in that**,
said compositional grading includes a composition of Ge₁₄Sb₂₉Te₅₇ graded to Ge₂₂Sb₂₂Te₅₆.

22. The memory element of claim 20,
**characterized in that,**
wherein said compositional layering includes discrete layers of Ge₁₄Sb₂₉Te₅₇ and Ge₂₂Sb₂₂Te₅₆.

23. The memory element of claim 20,
**characterized in that,**
said combination of compositional layering and compositional grading includes
a layer of Ge₂₂Sb₂₂Te₅₆ and a graded composition of Ge₁₄Sb₂₉Te₅₇ and Ge₂₂Sb₂₂Te₅₆, or
a layer of Ge₁₄Sb₂₉Te₅₇ and a graded composition of Ge₁₄Sb₂₉Te₅₇ and Ge₂₂Sb₂₂Te₅₆.

24. The memory element of one of the preceding claims,
**characterized in that,**
said volume of memory is operatively disposed in a pore having a diameter of less than 2 micrometer (microns), preferably less than about 1 micrometer (micron).

25. The memory element of one of the preceding claims,
**characterized in that,**
said selected electrical input signal is at least one electrical signal pulse between 1 and 25 volts, preferably between about 1 and about 2 volts, and has a signal duration of less than about 500 nanoseconds, preferably between about 100 and about 500 nanoseconds.

26. The memory element of claim 25,
**characterized in that,**
said selected electrical input signal is at least one electrical signal pulse with a pulse current of between about 0,5 and about 1 milliamperes.

27. The memory element of one of the claims 1 - 24,
**characterized in that,**
said selected electrical input signal is a plurality of electrical signal pulses, and a feedback loop is provided for initiating additional electrical signal pulses to insure that said memory element (30) is set at the selected resistance value.

28. The memory element of one of the preceding claims,
**characterized in that,**
said volume of memory material (36) contains crystallites which are less than about 100 nanometers (1000 Å) in major dimension.

29. The memory element of one of the preceding claims,
**characterized in that,**
said memory material (36) is deposited anisotropically in which the constituent atomic elements thereof are present in substantially discrete layers.

30. The memory element of one of the preceding claims,
**characterized in that,**
said volume of memory material (36) and said contacts (32, 34, 38, 40) are formed so as to define a matrix array of memory cells wherein each of said memory cells is addressably isolated from any other of said memory cells in said array by an isolation device, each of said memory cells in said array being setable by said selected electrical signals to any resistance value within said dynamic range regardless of the previous value to which said memory material (36) was set.

31. The memory element of claim 30,
**characterized in that,**
the combination of said memory cells and isolation devices define a three dimensional array of discretly addressable high density memory cells.

32. An electrically operated memory array (51) of memory elements (30) as claimed in one of the preceding claims, comprising:
- a substrate (10, 50);
- a plurality of said discretely addressable single-cell memory elements (30) spacedly disposed in a plurality of rows and columns on said substrate;
- an isolation device (26) associated with each discrete memory element (30) to electrically isolate said element from the remainder of said plurality of memory elements (30);
- each of said single-cell memory elements (30) defined by said volume of memory material (36),
said memory material (36) having an electrically modulatable Fermi level position, wherein said position has the ability to be modulated over a large dynamic range of substantially different electrical resistances while maintaining a substantially constant optical band gap; and
address lines (12, 42) making electrical contact on one side of each of said memory elements (30) with said volume of memory material (36) and on the other side of each of said memory elements (30) with said isolation device (26), thereby providing means for selectively and individually setting and reading the resistance values of each discrete memory element (30).

33. The memory array of claim 32,
**characterized in that,**
wherein said dynamic range and said multibit capabilities provides storage for at least 1 and ½ bits of binary information in a single cell memory element (30).

34. The memory array of one of the preceding claims,
**characterized in that**,
said isolation devices (26) are thin film p-i-n Si alloy diodes or transistors.

35. A method of modulating the electrical conductivity of a multielement composition of a volume of memory material (36) formed of a semiconductor material including at least one chalcogen element and capable of being switched between at least two electrically detectable states in response to selected electrical input signals, wherein said memory material (36) has a large dynamic range of substantially different electrical conductivities, and wherein in each of said electrically detectable states at least a portion of said volume of memory material (36) is in the crystalline state,
by applying said selected electrical input signal to said material (36) so as to add or substract charge carriers or so as to modulate the position of the Fermi level relative to the band edge in said material (36), whereby the electrical conductivity of the material (36) is modulated to a new value, regardless of the previous electrical conductivity of said memory material (36),
wherein the new value of electrical conductivity of the material (36) remains constant even after the application of said selected electrical input signal to said material (36) has been terminated.

36. A method as claimed in claim 35,
**characterized by,**
modulating the electrical conductivity by modulating the position of the Fermi level relative to the band edge in said volume of memory material (36), selected from the group consisting of Se, Te, Ge, Sb, Bi, Pb, Sn, As, S, Si, P, O and mixtures or alloys thereof, into any one of a plurality of metastable detectable positions, with a substantially constant optical band gap over said entire range by
- providing a homogeneous body of chalcogenide alloy material (36),
- applying said selected electrical input signal to said material (36) to modulate the position of the Fermi level thereof to a selected position relative to a band edge of said material (36) so as to obtain said new conductivity value,
wherein the position of the Fermi level thereof maintains at substantially the selected position to which it was modulated after the application of said selected electrical input signal to said material (36) has been terminated.

37. A method as claimed in claim 35,
**characterized by,**
modulating the electrical conductivity by intercoupling the constituent elements of said material (36) so as to define the lattice structure of crystallites of the material (36) ; and accomplishing said modulation by varying the concentration of free charge contributed by the atoms of at least one of said constituent elements of said multielement composition, and
- providing a composition of microcrystalline semiconductor material (36) which includes a volume fraction of crystallites, said crystallites defined by a lattice structure which incorporates atoms of each of the constituent elements in said composition;
- applying said selected electrical input signal to said material (36) so as to add or subtract charge carriers contributed by said one of the constituent elements in said composition, whereby the electrical conductivity of the material (36) is modulated to said new value which is dependent upon the concentration of free charge contributed by said one constituent element, wherein the concentration of free charge determined by said applied selected electrical input signal is maintained after the application of said selected electrical input signal to said material (36) has been terminated.

38. The method of claim 36 or 37,
**characterized by,**
the further step of forming said material (36) of a material including Te, Ge and Sb in the ratio TeₐGe_{b}Sb_{100-(a+b)} where the subscripts are in atomic percentages which total 100% of the constituent elements and 48 ≤ a ≤ 58 and 8 ≤ b ≤ 40.

39. The method of one of the claims 35 - 38,
**characterized by**,
the further step of repeating the application/termination of said selected electrical input signal to modulate the semiconductor material (36) to the same or a different electrical conductivity within said range.

40. The method of one of the claims 35 - 39,
**characterized by,**
the further step of providing said applied selected electrical input signal in the form of at least one electrical pulse of selected power and duration.

41. The method of one of the claims 37 - 40,
**characterized by,**
accomplishing the modulation of free charge carrier concentration by modulating the lattice interactions of the lone pair electrons.

## Patentansprüche

1. Elektrisch betriebenes Speicherelement (30), welches folgendes aufweist:
a) eine Masse an Speichermaterial (36), das aus einem Halbleitermaterial gebildet ist und mindestens ein chalcogenes Element enthält und im Ansprechen auf ausgewählte elektrische Eingangssignale zwischen mindestens zwei elektrisch erfassbaren Zuständen schaltbar ist, sowie
b) ein Paar im Abstand voneinander angeordnete Kontakte (32, 34, 38, 40) zum Zuführen der elektrischen Eingangssignale zu der Masse aus Speichermaterial (36),
**dadurch gekennzeichnet, dass**
mindestens ein Teil der Masse aus Speichermaterial (36) im kristallinen Zustand vorliegt,
die Masse aus Speichermaterial (36) im Ansprechen auf die ausgewählten elektrischen Eingangssignale
- Multibit-Speicherfähigkeiten über einen dynamischen Bereich von elektrischen Widerstandswerten besitzt und
- dabei direkt überschreibbar ist, mit der Fähigkeit, direkt auf einen aus einer Vielzahl von Widerstandswerten innerhalb des dynamischen Bereichs ohne die Notwendigkeit gesetzt zu werden, dass sie auf einen speziellen Ausgangs-Widerstandswert oder einen gelöschten Widerstandswert gesetzt wird, ohne Berücksichtigung des vorherigen Widerstandswerts des Speichermaterials (6).

2. Speicherelement nach Anspruch 1,
**dadurch gekennzeichnet, dass**
die Masse aus Speichermaterial (36) zwischen den Kontakten (32, 34, 38, 40) angeordnet ist, wobei die Kontakte (32, 34, 38, 40) Anschlüsse zum Auslesen gespeicherter Informationen und zum Schreiben von Informationen in das Speicherelement (30) bilden.

3. Speicherelement nach einem der vorhergehenden Ansprüche,
**dadurch gekennzeichnet, dass**
die Masse aus Speichermaterial (36) auf jeden der Widerstandswerte einstellbar ist, wobei das Speichermaterial (36) auf den Wert eingestellt bleibt, nachdem das Eingangssignal nicht mehr angelegt ist.

4. Speicherelement nach einem der vorhergehenden Ansprüche,
**dadurch gekennzeichnet, dass**
die Masse aus Speichermaterial (36) eine Dicke zwischen 50 Nanometer (500 Å) und 500 Nanometer (5000 Å) aufweist.

5. Speicherelement nach einem der vorhergehenden Ansprüche,
**dadurch gekennzeichnet, dass**
die Masse aus Speichermaterial (36) im Ansprechen auf die ausgewählten elektrischen Eingangssignale auf einen von mindestens 4 separaten erfassbaren Widerstandswerten innerhalb des dynamischen Bereichs einstellbar ist.

6. Speicherelement nach einem der vorhergehenden Ansprüche,
**dadurch gekennzeichnet, dass**
die Masse aus Speichermaterial (36) eines oder mehrere der Elemente enthält, die aus der Gruppe gewählt werden, die aus Se, Te und deren Gemischen oder Legierungen besteht.

7. Speicherelement nach einem der vorhergehenden Ansprüche,
**dadurch gekennzeichnet, dass**
die Masse aus Speichermaterial (36) eines oder mehrere der Elemente enthält, die aus der Gruppe gewählt werden, die aus Ge, Sb, Bi, Pb, Sn, As, S, Si, P, O und deren Gemischen oder Legierungen besteht.

8. Speicherelement nach Anspruch 7,
**dadurch gekennzeichnet, dass**
jedes der Elemente im gesamten Volumen der Masse des Speichermaterials (36) vorhanden ist und dieses durchzieht.

9. Speicherelement nach einem der vorhergehenden Ansprüche,
**dadurch gekennzeichnet, dass**
die Masse an Speichermaterial mindestens eines der Elemente enthält, die aus der Gruppe ausgewählt sind, die aus Cr, Fe, Ni und deren Gemischen oder Legierungen besteht.

10. Speicherelement nach einem der vorhergehenden Ansprüche,
**dadurch gekennzeichnet, dass**
die Masse an Speichermaterial (36) Te, Ge und Sb im Verhältnis TeₐGe_{b}Sb_{100-(a+b)} enthält, wobei die tiefgestellten Indizes in Atomprozentanteilen ausgedrückt sind, die zusammen 100 % der beteiligten Elemente betragen und wobei gilt: 40 ≤ a ≤ 58 und 8 ≤ b ≤ 40.

11. Speicherelement nach einem der vorhergehenden Ansprüche,
**dadurch gekennzeichnet, dass**
jeder Kontakt (32, 34, 38, 40) des Paares im Abstand voneinander angeordneter Kontakte (32, 34, 38, 40) eine Dünnfilmschicht aus Siliziummaterial enthält, die in direktem Kontakt mit der Masse des Speichermaterials (36) angeordnet ist.

12. Speicherelement nach Anspruch 11,
**dadurch gekennzeichnet, dass**
jeder der beiden im Abstand voneinander angeordneten Kontakte (32, 34, 38, 40) eine Dünnfilmschicht aus Kohlenstoffmaterial enthält, die auf einer Seite der Dünnfilmschicht aus Siliziummaterial angeordnet ist, die von der Masse aus Speichermaterial (36) entfernt liegt.

13. Speicherelement nach Anspruch 12,
**dadurch gekennzeichnet, dass**
jeder der beiden im Abstand voneinander angeordneten Kontakte (32, 34, 38, 40) eine Dünnfilmschicht aus Molybdänmaterial enthält, die auf der Dünnfilmschicht aus Kohlenstoffmaterial angeordnet ist.

14. Speicherelement nach Anspruch 11,
**dadurch gekennzeichnet, dass**
die Dünnfilmschicht aus Siliziummaterial der im Abstand voneinander angeordneten Kontakte (32, 34, 38, 40) ursprünglich in einem amorphen Zustand angeordnet ist, wobei ein Teil der Dünnfilmschichten zur Kristallisierung während eines anfänglichen Form-/Schaltvorgangs in der Lage ist.

15. Speicherelement nach Anspruch 12 oder 13,
**dadurch gekennzeichnet, dass**
die Dünnfilmschichten aus Silizium- und Kohlenstoffmaterial der im Abstand voneinander angeordneten Kontakte (32, 34, 38, 40) ursprünglich in einem amorphen Zustand vorliegen, wobei ein Teil der Dünnfilmschichten zur Kristallisierung während eines anfänglichen Form-/Schaltvorgangs in der Lage ist.

16. Speicherelement nach einem der vorhergehenden Ansprüche,
**dadurch gekennzeichnet, dass**
die Masse aus Speichermaterial (36) eine Einrichtung zum Verändern der positionsbezogenen Zusammensetzung der Masse aus Speichermaterial (36) aufweist, um so den Widerstand des Speichermaterials (36) auf einem gewählten Widerstandswert im wesentlichen zu stabilisieren und um die Masse an Speichermaterial (36) nach Beendigung des Eingangssignals auf dem gewählten Widerstandswert ohne Abweichung eingestellt zu halten.

17. Speicherelement nach Anspruch 16,
**dadurch gekennzeichnet, dass**
die Einrichtung zum Verändern der positionsbezogenen Zusammensetzung der Masse an Speichermaterial (36) den Zusatz eines Elements zum Verbreitern einer Bandlücke zu der Masse an Speichermaterial (36) enthält.

18. Speicherelement nach Anspruch 16,
**dadurch gekennzeichnet, dass**
die Einrichtung zum Verändern der positionsbezogenen Zusammensetzung der Masse an Speichermaterial (36) eine Steigerung der kovalenten Bindung umfasst.

19. Speicherelement nach Anspruch 16,
**dadurch gekennzeichnet, dass**
die Masse an Speichermaterial (36) als Bestandteil mindestens ein atomares Element umfasst, welches Elemente mit freiem Elektronenpaar enthält, und dass die Einrichtung zum Verändern der positionsbezogenen Zusammensetzung der Masse an Speichermaterial (36) eine Modifizierung der örtlichen Umgebung der Elektronen aus einem freien Elektronenpaar umfasst, um Störstellenzustände in der Bandlücke des Halbleitermaterials zu schaffen oder aufzuheben.

20. Speicherelement nach Anspruch 16,
**dadurch gekennzeichnet, dass**
die Einrichtung zum Verändern der Zusammensetzung eine Abstufung der Zusammensetzung und/oder eine Schichtenbildung in der Zusammensetzung in der Masse an Speichermaterial (36) umfasst.

21. Speicherelement nach Anspruch 20,
**dadurch gekennzeichnet, dass**
die Abstufung in der Zusammensetzung eine Zusammensetzung von Ge₁₄Sb₁₉Te₅₇ umfasst, die auf Ge₂₂Sb₂₂Te₅₆ abgestuft ist.

22. Speicherelement nach Anspruch 20,
**dadurch gekennzeichnet, dass**
die Schichtenbildung in der Zusammensetzung diskrete Schichten aus Ge₁₄Sb₁₉Te₅₇ und Ge₂₂Sb₂₂Te₅₆ umfasst.

23. Speicherelement nach Anspruch 20,
**dadurch gekennzeichnet, dass**
die Kombination aus Schichtbildung in der Zusammensetzung und aus Abstufung in der Zusammensetzung folgendes umfasst:
eine Schicht aus Ge₂₂Sb₂₂Te₅₆ und eine abgestufte Zusammensetzung aus Ge₁₄Sb₁₉Te₅₇ und Ge₂₂Sb₂₂Te₅₆, oder
eine Schicht aus Ge₁₄Sb₁₉Te₅₇ und eine abgestufte Zusammensetzung aus Ge₁₄Sb₁₉Te₅₇ und Ge²²Sb₂₂Te₅₆.

24. Speicherelement nach einem der vorhergehenden Ansprüche,
**dadurch gekennzeichnet, dass**
die Masse an Speichermaterial funktionsmäßig in einer Pore mit einem Durchmesser von weniger als 2 Mikrometern (Mikron), vorzugsweise von weniger als etwa 1 Mikrometer (Mikron), angeordnet ist.

25. Speicherelement nach einem der vorhergehenden Ansprüche,
**dadurch gekennzeichnet, dass**
das ausgewählte elektrische Eingangssignal mindestens ein elektrischer Signalimpuls mit einem Wert zwischen 1 und 25 Volt, vorzugsweise zwischen etwa 1 und etwa 2 Volt, ist und eine Signalbreite von weniger als etwa 500 Nanosekunden, vorzugsweise zwischen etwa 100 und etwa 500 Nanosekunden, besitzt.

26. Speicherelement nach Anspruch 25,
**dadurch gekennzeichnet, dass**
das ausgewählte elektrische Eingangssignal mindestens ein elektrischer Signalimpuls mit einer Impuls-Stromstärke auf einem Wert zwischen etwa 0,5 und etwa 1 Milliampere ist.

27. Speicherelement nach einem der Ansprüche 1 bis 24,
**dadurch gekennzeichnet, dass**
das ausgewählte elektrische Eingangssignal eine Vielzahl von elektrischen Signalimpulsen darstellt, und dass eine Rückkoppelschleife zur Einleitung zusätzlicher elektrischer Signalimpulse vorgesehen ist, um sicherzustellen, dass das Speicherelement (30) auf den ausgewählten Widerstandswert eingestellt ist.

28. Speicherelement nach einem der vorhergehenden Ansprüche,
**dadurch gekennzeichnet, dass**
die Masse aus Speichermaterial (36) Kristallite enthält, die in ihrer größeren Abmessung weniger als etwa 100 Nanometer (1000 Å) betragen.

29. Speicherelement nach einem der vorhergehenden Ansprüche,
**dadurch gekennzeichnet, dass**
das Speichermaterial (36) anisotrop aufgebracht wird, wobei die atomaren Elemente als seine Bestandteile in im Wesentlichen diskreten Schichten vorhanden sind.

30. Speicherelement nach einem der vorhergehenden Ansprüche,
**dadurch gekennzeichnet, dass**
die Masse an Speichermaterial (36) und die Kontakte (32, 34, 38, 40) so gebildet sind, dass sie eine Matrixanordnung aus Speicherzellen definieren, bei welcher jede der Speicherzellen in adressierbarer Form von jeder anderen der Speicherzellen in der Anordnung durch eine Isoliervorrichtung isoliert ist, wobei jede der Speicherzellen in der Anordnung durch die ausgewählten elektrischen Signale auf irgendeinen Widerstandswert innerhalb des dynamischen Bereichs einstellbar ist, ohne Berücksichtigung des vorhergehenden Werts, auf den das Speichermaterial (36) eingestellt war.

31. Speicherelement nach Anspruch 30,
**dadurch gekennzeichnet, dass**
die Kombination aus den Speicherzellen und Isoliervorrichtungen eine dreidimensionale Anordnung aus diskret adressierbaren hochdichten Speicherzellen definieren.

32. Elektrisch betriebene Speicheranordnung (51) aus Speicherelementen (30)
nach einem der vorhergehenden Ansprüche, welche folgendes aufweist:
- ein Substrat (10, 50);
- eine Vielzahl der diskret adressierbaren Einzelzellen-Speicherelemente (30), die im Abstand voneinander in einer Vielzahl von Zeilen und Spalten auf dem Substrat angeordnet sind;
- eine Isoliervorrichtung (26), die jedem diskreten Speicherelement (30) zugeordnet ist, um das Element vom Rest der Vielzahl aus Speicherelementen (30) zu isolieren;
- wobei jedes der Einzelzellen-Speicherelemente (30) durch die Masse an Speichermaterial (36) definiert wird,
bei welcher das Speichermaterial (36) eine elektrisch modulierbare Position der Fermi-Grenze aufweist und die Position in der Lage ist, über einen großen dynamischen Bereich von wesentlich verschiedenen elektrischen Widerständen moduliert zu werden, während eine im wesentlichen konstante optische Bandlücke aufrechterhalten wird; und
bei welcher Adresszeilen (12, 42) auf einer Seite jedes der Speicherelemente (30) mit der Masse an Speichermaterial (36) und auf der anderen Seite jedes der Speicherelemente (30) mit der Isoliervorrichtung (26) einen elektrischen Kontakt herstellen, wodurch eine Einrichtung zum selektiven und individuellen Einstellen und Lesen der Widerstandswerte jedes diskreten Speicherelements (30) gebildet wird.

33. Speicheranordnung nach Anspruch 32,
**dadurch gekennzeichnet, dass**
der dynamische Bereich und die Multibit-Möglichkeiten Speicherplatz für mindestens 1 ½ Bit an Binärinformation in einem Einzelzellen-Speicherelement (30) scharfen.

34. Speicheranordnung nach einem der vorhergehenden Ansprüche,
**dadurch gekennzeichnet, dass**
die Isoliervorrichtungen (26) Dünnfilm-Dioden oder Transistoren vom Typ p-i-n aus Si-Legierung sind.

35. Verfahren zum Modulieren der elektrischen Leitfähigkeit einer Multielement-Zusammensetzung einer Masse aus Speichermaterial (36), die aus einem Halbleitermaterial besteht und mindestens ein chalcogenes Element enthält und in der Lage ist, im Ansprechen auf ausgewählte elektrische Eingangssignale zwischen mindestens zwei elektrisch erfassbaren Zuständen umgeschaltet zu werden, bei welchem das Speichermaterial (36) einen großen dynamischen Bereich an erheblich unterschiedlichen elektrischen Leitfähigkeiten aufweist und bei welchem sich in jedem der elektrisch erfassbaren Zustände zumindest ein Teil der Masse an Speichermaterial (36) im kristallinen Zustand befindet,
bei welchem das ausgewählte elektrische Eingangssignal an das Material angelegt wird, um so Ladungsträger zu addieren oder zu subtrahieren oder um die Position der Fermi-Grenze relativ zum Rand des Bandes in dem Material (36) zu modulieren, wodurch die elektrische Leitfähigkeit des Materials (36) auf einen neuen Wert moduliert wird, ohne Berücksichtigung des vorangegangenen Werts der elektrischen Leitfähigkeit des Speichermaterials (36),
wobei der neue Wert der elektrischen Leitfähigkeit des Materials (36) auch dann konstant bleibt, nachdem das Anlegen des ausgewählten elektrischen Eingangssignals an das Material (36) beendet ist.

36. Verfahren nach Anspruch 35,
**gekennzeichnet durch**
das Modulieren der elektrischen Leitfähigkeit **durch** Modulation der Lage der Fermi-Grenze relativ zum Rand des Bandes in der Masse an Speichermaterial (36), die aus der Gruppe ausgewählt ist, die aus Se, Te, Ge, Sb, Bi, Pb, Sn, As, S, Si, P, O sowie deren Gemischen oder Legierungen besteht, zu einer beliebigen Position aus einer Vielzahl von metastabilen erfassbaren Positionen bei einer erheblich konstanten optischen Bandlücke über den gesamten Bereich **durch**
- Vorsehen eines homogenen Körpers aus Chalcogenid-Legierungsmaterial (36),
- Anlegen des ausgewählten elektrischen Eingangssignals an das Material (36) zum Modulieren der Position von dessen Fermi-Grenze auf eine ausgewählte Position relativ zu einem Rand des Bandes des Materials (36), um so den neuen Wert für die Leitfähigkeit zu erhalten, wobei die Lage der Fermi-Grenze des Materials im wesentlichen auf der ausgewählten Position gehalten wird, auf die das Niveau moduliert wurde, nachdem das Anlegen des ausgewählten elektrischen Eingangssignals an das Material (36) beendet wurde.

37. Verfahren nach Anspruch 35,
**gekennzeichnet durch**
das Modulieren der elektrischen Leitfähigkeit **durch** Verkoppeln der das Material (36) bildenden Elemente untereinander, um so die Gitterstruktur der Kristallite des Materials (36) zu definieren; und
**durch** Erzielen der Modulation **durch** Veränderung der Konzentration an freier Ladung, die von den Atomen von mindestens einem der die Zusammensetzung aus mehreren Elementen bildenden Elemente beigesteuert wird, und
- Bilden einer Zusammensetzung aus mikro-kristallinem Halbleitermaterial (36), welches einen Volumenanteil an Kristalliten umfasst, wobei die Kristallite von Elementen einer Gitterstruktur definiert werden, in welche Atome von jedem der die Zusammensetzung bildenden Elemente einbezogen sind;
- Anlegen des ausgewählten elektrischen Eingangssignals an das Material (36), um auf diese Weise Ladungsträger zu addieren oder zu subtrahieren, die von einem der die Zusammensetzung bildenden Elemente beigesteuert werden, wodurch die elektrische Leitfähigkeit des Materials (36) auf den neuen Wert moduliert wird, der von der Konzentration an freier Ladung abhängig ist, die von einem der die Zusammensetzung bildenden Elemente beigesteuert wird, wobei die Konzentration an freier Ladung, die **durch** das ausgewählte elektrische Eingangssignal bestimmt ist, aufrechterhalten wird, nachdem das Anlegen des ausgewählten elektrischen Eingangssignals an das Material (36) beendet wurde.

38. Verfahren nach Anspruch 36 oder 37,
**gekennzeichnet durch**
den weiteren Schritt zur Bildung des Materials (36) aus einem Werkstoff, der Te, Ge und Sb im Verhältnis TeₐGe_{b}Sb_{100-(a+b)} enthält, wobei die tiefgestellten Indizes in Atomprozentanteilen ausgedrückt sind, die zusammen 100 % der beteiligten Elemente betragen und wobei gilt: 40 ≤ a ≤ 58 und 8 ≤ b ≤ 40.

39. Verfahren nach einem der Ansprüche 35 bis 38,
**gekennzeichnet durch**
den weiteren Schritt, das Anlegen/Beenden des ausgewählten elektrischen Eingangssignals zur Modulation des Halbleitermaterials (36) auf denselben oder einen anderen Wert der elektrischen Leitfähigkeit innerhalb des Bereichs zu wiederholen.

40. Verfahren nach einem der Ansprüche 35 bis 39,
**gekennzeichnet durch**
den weiteren Schritt, das angelegte ausgewählte elektrische Eingangssignal in Form von mindestens einem elektrischen Impuls von ausgewählter Energie und Dauer zu liefern.

41. Verfahren nach einem der Ansprüche 37 bis 40,
**gekennzeichnet durch**
das Erzielen der Modulation der Konzentration an freien Ladungsträgern **durch** Modulieren der Wechselwirkungen der Elektronen aus einem freien Elektronenpaar im Gitter.

## Revendications

1. Élément de mémoire (30) commandé par électricité, qui comprend:
a) un volume de matériau de mémoire (36), qui est fait d'un matériau semi-conducteur et contient au moins un élément chalcogène et qui est commutable, en réponse aux signaux électriques d'entrée choisis, entre au moins deux états électriquement détectables,
b) ainsi qu'une paire de contacts disposés à un écart l'un de l'autre (32, 34, 38, 40) pour l'alimentation des signaux électriques d'entree au volume de matériau de mémoire (36),
**caractérisé en ce**
**qu'**au moins une partie du volume de matériau de mémoire (36) est présent en état cristallin,
**que** le volume de matériau de mémoire (36), en réponse aux signaux électriques d'entrée choisis,
- est pourvu des capacités multi bit sur une gamme dynamique des valeurs de la résistance électrique,
- en étant apte à être directement écrasé, à la capacité d'être réglé directement à une parmi une pluralité de valeurs de la résistance au-dedans de la gamme dynamique, sans la nécessité de le régler à une valeur initiale particulière de la valeur de la résistance ou à une valeur de la résistance effacée, sans égard à la valeur précédente de la résistance du matériau de mémoire (6).

2. Élément de mémoire selon la revendication 1,
**caractérisé en ce**
**que** le volume de matériau de mémoire (36) est disposé entre lesdits contacts (32, 34, 38, 40), lesdits contacts (32, 34, 38, 40) constituant des bornes pour la lecture des informations enregistrées et pour l'écriture des informations dans l'élément de mémoire (30).

3. Élément de mémoire selon une quelconque des revendications précédentes,
**caractérisé en ce**
**que** le volume de matériau de mémoire (36) est réglable à chacune des valeurs de la résistance, le matériau de mémoire (36) restant réglé à la valeur suivant la terminaison de l'application du signal choisi d'entrée.

4. Élément de mémoire selon une quelconque des revendications précédentes,
**caractérisé en ce**
**que** le volume de matériau de mémoire (36) a une épaisseur entre 50 nanomètres (500 Å) et 500 nanomètres (5000 Å).

5. Élément de mémoire selon une quelconque des revendications précédentes,
**caractérisé en ce**
**que** le volume de matériau de mémoire (36) est réglable, en réponse aux signaux électriques d'entrée choisis, à un parmi au moins 4 valeurs de la résistance, qui sont détectables de façon séparée, au-dedans de la gamme dynamique.

6. Élément de mémoire selon une quelconque des revendications précédentes,
**caractérisé en ce**
**que** le volume de matériau de mémoire (36) contient un ou plusieurs des éléments choisis du groupe formé par Se, Te et leurs mélanges ou alliages.

7. Élément de mémoire selon une quelconque des revendications précédentes,
**caractérisé en ce**
**que** le volume de matériau de mémoire (36) contient un ou plusieurs des éléments choisis du groupe formé par Ge, Sb, Bi, Pb, Sn, As, S, Si, P, O et leurs mélanges ou alliages.

8. Élément de mémoire selon la revendication 7,
**caractérisé en ce**
**que** chacun desdits éléments est présent dans tout le volume dudit volume du matériau de mémoire (36) de façon entrelacée.

9. Élément de mémoire selon une quelconque des revendications précédentes,
**caractérisé en ce**
**que** le volume de matériau de mémoire contient au moins un des éléments choisis du groupe formé par Cr, Fe, Ni et leurs mélanges ou alliages.

10. Élément de mémoire selon une quelconque des revendications précédentes,
**caractérisé en ce**
**que** le volume de matériau de mémoire (36) contient du Te, Ge et Sb en un rapport de TeₐGe_{b}Sb_{100-(a+b)}, les indices inférieurs étant exprimés en pour centiles atomiques, qui correspondent à 100 % des éléments constituants au total, où s'applique: 40 ≤ a ≤ 58 et 8 ≤ b ≤ 40.

11. Élément de mémoire selon une quelconque des revendications précédentes,
**caractérisé en ce**
**que** chaque contact (32, 34, 38, 40) de la paire de contacts disposé à un écart l'un de l'autre comprend une couche mince en matériau en silicium, qui est disposée en contact direct avec le volume du matériau de mémoire (36).

12. Élément de mémoire selon la revendication 11,
**caractérisé en ce**
**que** chacun desdits deux contacts écartés l'un de l'autre (32, 34, 38, 40) comprend une couche mince en matériau en carbone, qui est disposé d'un côté de ladite couche mince en matériau en silicium, qui est éloigné du volume de matériau de mémoire (36).

13. Élément de mémoire selon la revendication 12,
**caractérisé en ce**
**que** chacun desdits contacts écartés l'un de l'autre (32, 34, 38, 40) comprend une couche mince en matériau en molybdène, qui est disposé sur ladite couche mince en matériau en carbone.

14. Élément de mémoire selon la revendication 11,
**caractérisé en ce**
**que** ladite couche mince en matériau en silicium desdits contacts écartés l'un de l'autre (32, 34, 38, 40) est d'abord prévue en un état amorphe, à une partie desdites couches minces étant capable de cristalliser au cours d'une opération de formage/commutation initiale.

15. Élément de mémoire selon la revendication 12 ou 13,
**caractérisé en ce**
**que** lesdites couches minces en matériau en silicium et en carbone desdits contacts écartés l'un de l'autre (32, 34, 38, 40) sont d'abord prévues en un état amorphe, à une partie desdites couche minces étant capable de cristalliser au cours d'une opération de formage/commutation initiale.

16. Élément de mémoire selon une quelconque des revendications précédentes,
**caractérisé en ce**
**que** le volume de matériau de mémoire (36) comprend un moyen à varier la composition locale du volume de matériau de mémoire (36) afin de stabiliser essentiellement la résistance du matériau de mémoire (36) à une valeur choisie de la résistance et afin de maintenir le réglage du volume de matériau de mémoire (36) à la valeur choisie de la résistance sans dérive suivant la terminaison dudit signal d'entrée.

17. Élément de mémoire selon la revendication 16,
**caractérisé en ce**
**que** ledit moyen à varier la composition locale du volume de matériau de mémoire (36) contient l'ajoutage d'un élément à élargir une lacune de bande audit volume de matériau de mémoire (36).

18. Élément de mémoire selon la revendication 16,
**caractérisé en ce**
**que** ledit moyen à varier la composition locale du volume de matériau de mémoire (36) comprend une augmentation de la liaison homopolaire.

19. Élément de mémoire selon la revendication 16,
**caractérisé en ce**
**que** le volume de matériau de mémoire (36) comprend, comme constituant, au moins un élément atomique, qui contient des éléments à doublet libre, et en ce que ledit moyen à varier la composition locale du volume de matériau de mémoire (36) comprend une modification de l'environnement local des électrons d'un doublet libre, afin de créer ou supprimer des état d'imperfection dans ladite lacune de bande du matériau semi-conducteur

20. Élément de mémoire selon la revendication 16,
**caractérisé en ce**
**que** ledit moyen à varier la composition comprend une gradation de la composition et/ou une formation de couches dans la composition du volume de matériau de mémoire (36).

21. Élément de mémoire selon la revendication 20,
**caractérisé en ce**
**que** la gradation de la composition comprend une composition de Ge₁₄Sb₁₉Te₅₇, qui est variée par degrés à Ge₂₂Sb₂₂Te₅₆.

22. Élément de mémoire selon la revendication 20,
**caractérisé en ce**
**que** la formation de couches dans la composition comprend des couches discrètes en Ge₁₄Sb₁₉Te₅₇ et Ge₂₂Sb₂₂Te₅₆.

23. Élément de mémoire selon la revendication 20,
**caractérisé en ce**
**que** la combinaison de la formation de couches dans la composition avec la gradation de la composition comprend:
une couche en Ge₂₂Sb₂₂Te₅₆ et une composition variée par degrés en Ge₁₄Sb₁₉Te₅₇ et Ge₂₂Sb₂₂Te₅₆ ou
une couche en Ge₁₄Sb₁₉Te₅₇ et une composition variée par degrés en Ge₁₄Sb₁₉Te₅₇ et Ge²²Sb₂₂Te₅₆.

24. Élément de mémoire selon une quelconque des revendications précédentes,
**caractérisé en ce**
**que** le volume de matériau de mémoire est disposé, par ses fonctions, dans un pore à un diamètre de moins de 2 micromètres (micron), de préférence de moins de 1 micromètre (micron) environ.

25. Élément de mémoire selon une quelconque des revendications précédentes,
**caractérisé en ce**
**que** ledit signal électrique d'entrée choisi est au moins une impulsion de signal électrique à une valeur entre 1 et 25 Volt, de préférence entre 1 Volt environ et 2 Volt environ, et a une largeur de signal de moins de 500 nanosecondes environ, de préférence entre 100 nanosecondes environ et 500 nanosecondes environ.

26. Élément de mémoire selon la revendication 25,
**caractérisé en ce**
**que** ledit signal électrique d'entrée choisi est au moins une impulsion de signal électrique à une intensité du courant d'impulsion à une valeur entre 0,5 milliampère environ et 1 milliampère environ.

27. Élément de mémoire selon une quelconque des revendications 1 bis 24,
**caractérisé en ce**
**que** ledit signal électrique d'entrée choisi représente un grand nombre d'impulsions des signaux électriques, et en ce qu'une boucle de réinjection est prévue pour l'initiation des impulsions additionnelles des signaux électriques afin d'assurer, que l'élément de mémoire (30) soit réglé à la valeur choisie de la résistance.

28. Élément de mémoire selon une quelconque des revendications précédentes,
**caractérisé en ce**
**que** le volume de matériau de mémoire (36) contient des cristallites, dont la dimension majeure correspond à moins de 100 nanomètres (1000 Å) environ.

29. Élément de mémoire selon une quelconque des revendications précédentes,
**caractérisé en ce**
**que** le matériau de mémoire (36) est déposé par une technique anisotrope, lesdits éléments atomiques, en tant que ses constituants, étant présents sous forme de couches essentiellement discrètes.

30. Élément de mémoire selon une quelconque des revendications précédentes,
**caractérisé en ce**
**que** le volume de matériau de mémoire (36) et lesdits contacts (32, 34, 38, 40) sont configurés de façon à définir un arrangement en matrice de cellules de mémoire, dans lequel chacune desdites cellules de mémoire dans la matrice est isolée, de manière adressable, de chaque autre parmi lesdites cellules de mémoire moyennant un dispositif isolant, à chacune desdites cellules de mémoire dans la matrice étant réglable par lesdits signaux électriques choisis à une valeur quelconque de la résistance au-dedans de la gamme dynamique, sans égard à la valeur précédente, à laquelle le matériau de mémoire (36) était réglé.

31. Élément de mémoire selon la revendication 30,
**caractérisé en ce**
**que** la combinaison desdits cellules de mémoire et desdits dispositifs isolants définit une matrice tridimensionnelle de cellules de mémoire à haute densité, qui sont adressable de façon discrète.

32. Matrice de mémoire, commandée par électricité, composée des éléments de mémoire (30) selon une quelconque des revendications précédentes, qui comprend:
- un substrat (10, 50);
- une pluralité des éléments de mémoire à une seule cellule (30), qui sont aptes à être adressé de façon discrète et qui sont disposées, à un écart l'une de l'autre, sur ledit substrat dans une pluralité de lignes et colonnes;
- un dispositif isolant (26), qui est affecté à chaque élément de mémoire discrète (30) afin d'isoler cet élément du reste de la pluralité des éléments de mémoire (30);
- à chacun desdits éléments de mémoire à une seule cellule (30) étant défini par le volume de matériau de mémoire (36),
dans laquelle le matériau de mémoire (36) présente une position du niveau de Fermi, qu'on peut moduler de manière électrique, et la position est capable d'être modulée sur une large gamme dynamique des résistances électriques essentiellement différentes, pendant qu'une lacune de bande optique, essentiellement constante, est maintenue, et
dans laquelle des lignes d'adresse (12, 42) établissent, d'un côté de chacun desdites éléments de mémoire (30), un contact électrique avec le volume de matériau de mémoire (36) et. d'autre côté, mettent chacun desdites éléments de mémoire (30) en contact électrique avec ledit dispositif isolant (26), en formant un moyen de réglage sélectif et individuel et de lecture des valeurs de la résistance de chaque élément de mémoire discrète (30).

33. La matrice de mémoire selon la revendication 32,
**caractérisé en ce**
**que** ladite gamme dynamique et les potentiels multi bit créent de l'espace mémoire pour au moins 1 ½ bits d'information binaires dans ledit élément de mémoire à une seule cellule (30).

34. La matrice de mémoire selon une quelconque des revendications précédentes,
**caractérisé en ce**
**que** lesdits dispositifs isolants (26) sont des diodes ou transistors à jonctions p-i-n à couche mince en alliage de Si.

35. Procédé à moduler la conductivité électrique d'une composition multi élémentaire d'un volume de matériau de mémoire (36), qui consiste en un matériau semi-conducteur et contient au moins un élément chalcogène et est capable, en réponse aux signaux électriques d'entrée choisis, d'être commuté entre au moins deux états électriquement détectables, dans lequel procédé le matériau de mémoire (36) présente une large gamme dynamique de conductivités électriques essentiellement différentes et dans lequel au moins une partie du volume de matériau de mémoire (36) est présent en un état cristallin en chaque état électriquement détectable,
dans lequel le signal électrique d'entrée choisi est appliqué au matériau afin d'additionner ou de soustraire des porteurs de charge ou afin de moduler la position du niveau de Fermi relativement au bord de la bande dans le matériau (36), ce qui mène à une modulation de la conductivité électrique du matériau (36) à une nouvelle valeur, sans égard à la valeur précédente de la conductivité électrique du matériau de mémoire (36),
ladite nouvelle valeur de la conductivité électrique du matériau (36) restant constant aussi suivant la terminaison des l'application dudit signal électrique d'entrée choisi au matériau (36).

36. Procédé selon la revendication 35,
**caractérisé par**
la modulation de la conductivité électrique en modulant la position du niveau de Fermi relativement au bord de la bande dans le volume de matériau de mémoire (36), qui est choisi du group formé par Se, Te, Ge, Sb, Bi, Pb, Sn, As, S, Si, P, O ainsi que leurs mélanges ou alliages, à une position quelconque d'une pluralité de positions métastables détectables à une lacune de bande optique essentiellement constante sur toute la gamme, en
- disposant un corps homogène en un matériau allié à chalcogénide (36),
- appliquant un signal électrique d'entrée choisi audit matériau afin de moduler la position de son niveau de Fermi à une position choisie relative au bord de la bande du matériau (36) afin d'achever la nouvelle valeur de la conductivité, la position du niveau de Fermi du matériau étant maintenue essentiellement à la position choisie, à laquelle le niveau était modulé, suivant la terminaison de l'application dudit signal électrique d'entrée choisi au matériau (36).

37. Procédé selon la revendication 35,
**caractérisé par**
la modulation de la conductivité électrique par inter couplage des éléments constituants le matériau (36) afin de définir la structure réticulaire des cristallites du matériau (36); et
par achèvement de la modulation par variation de la concentration de la charge libre, qui est contribuée par les atomes d'au moins un élément parmi les éléments qui constituent la composition de plusieurs éléments, et
- en formant une composition d'un matériau semi-conducteur micro cristallin (36), qui contient une fraction de volume des cristallites, les cristallites étant formés par des éléments d'une structure réticulaire, qui renferme des atomes de chaque élément parmi les éléments, qui constituent la composition;
- en appliquant ledit signal électrique d'entrée choisi audit matériau (36) afin d'additionner ou soustraire des porteurs de charge, qui sont contribués par un des éléments parmi les éléments, qui constituent la composition, ce qui module la conductivité électrique du matériau (36) à la nouvelle valeur, qui dépend de la concentration de charge libre, qui est contribuée par un parmi les éléments, qui constituent la composition, la concentration de charge libre, qui est déterminée par le signal électrique d'entrée choisi, étant maintenue suivant la terminaison de l'application dudit signal électrique d'entrée choisi au matériau (36).

38. Procédé selon la revendication 36 ou 37,
**caractérisé par**
l'étape suivante de formation du matériau (36) d'une matière, qui contient Te, Ge et Sb en un rapport de TeₐGe_{b}Sb_{100-(a+b)}, les indices inférieurs étant exprimés en pour centiles atomiques, qui correspondent à 100 % des éléments constituants au total, où s'applique: 40 ≤ a ≤ 58 et 8 ≤ b ≤ 40.

39. Procédé selon une quelconque des revendications 35 à 38,
**caractérisé par**
l'étape suivante d'application/terminaison répétée du signal électrique d'entrée choisi afin de moduler le matériau semi-conducteur (36) à la même ou à une autre valeur de la conductivité électrique au-dedans de ladite gamme.

40. Procédé selon une quelconque des revendications 35 à 39,
**caractérisé par**
l'étape suivante d'alimentation du signal électrique d'entrée choisi appliqué sou forme d'au moins une impulsion électrique d'une puissance et durée choisie.

41. Procédé selon une quelconque des revendications 37 à 40,
**caractérisé par**
l'achèvement de la modulation de la concentration des porteurs de charge libres par modulation des interactions parmi les électrons d'un doublet libre dans le réseau cristallin.
